# EUROPEAN PATENT SPECIFICATION

(11) **EP 4 345 909 B1**
(45) Date of publication and mention of the grant of the patent: **25.03.2026**
(21) Application number: 22860534.1
(22) Date of filing: 24.08.2022
(51) Int. Cl.: H01L 21/34, H01L 21/443, H10D 64/68, H01L 21/441, H10D 30/67, H10D 99/00, H10D 64/27, H10D 30/60, H10D 64/66, H10D 48/30

(54) **OXIDE THIN FILM TRANSISTOR AND MANUFACTURING METHOD THEREFOR, AND ELECTRONIC DEVICE**
OXIDDÜNNSCHICHTTRANSISTOR UND HERSTELLUNGSVERFAHREN DAFÜR SOWIE ELEKTRONISCHE VORRICHTUNG
TRANSISTOR À COUCHES MINCES À OXYDE ET SON PROCÉDÉ DE FABRICATION, ET DISPOSITIF ÉLECTRONIQUE

(30) Priority: 27.08.2021 CN 202110994590
(43) Date of publication of application: 03.04.2024
(73) Proprietor: BOE Technology Group Co., Ltd., Chaoyang District, Beijing 100015 (CN)
(72) Inventor: WANG, Lizhong, Beijing 100176 (CN); YUAN, Guangcai, Beijing 100176 (CN); NING, Ce, Beijing 100176 (CN); HU, Hehe, Beijing 100176 (CN); YAO, Nianqi, Beijing 100176 (CN); XUE, Dapeng, Beijing 100176 (CN); DONG, Shuilang, Beijing 100176 (CN); LEI, Liping, Beijing 100176 (CN); WANG, Dongfang, Beijing 100176 (CN); LI, Zhengliang, Beijing 100176 (CN)
(74) Representative: Brötz, Helmut
(86) International application number: PCT/CN2022/114480
(87) International publication number: WO 2023/025188

(56) References cited:
- CN-A- 102 664 194
- CN-A- 103 247 537
- CN-A- 109 616 418
- CN-A- 111 554 694
- US-A1- 2003 122 204
- US-A1- 2016 218 114
- US-A1- 2016 351 720
- US-A1- 2018 331 228
- US-B2- 9 484 253

## Description

The present application claims the priority of China patent application No. 202110994590.4 filed on August 27, 2021.

### TECHNICAL FIELD

At least one embodiment of the present disclosure relates to an oxide thin film transistor, a preparation method of the oxide thin film transistor, and an electronic device.

### BACKGROUND

Oxide semiconductor thin film transistors have the advantages of high mobility, good stability and simple fabrication process, etc. Oxide semiconductor materials such as indium gallium zinc oxide (IGZO) are widely used in thin film transistor liquid crystal display (TFT-LCD) and active matrix organic light emitting diode panel (AMOLED).

Thin film transistors can be divided into a top gate structure and a bottom gate structure according to the position of gate electrode relative to the active region, and can be divided into a top contact structure and a bottom contact structure according to the position of the source electrode and the drain electrode relative to the active region, that is, there are four common structures of thin film transistors: bottom gate top contact (bottom gate staggered), bottom gate bottom contact (bottom gate coplanar), top gate top contact (top gate coplanar) and top gate bottom contact (top gate staggered). At present, the structure of oxide semiconductor layer thin film transistor mainly includes three types: etch-blocking type, back-channel etching type and coplanar type. The technological process of making the metal oxide thin film transistor of the back-channel etching type is relatively simple, and the photolithography process is one less than that of the etch-blocking type, which can reduce the equipment investment and improve the production efficiency. Patent document US 2018/331228 discloses an oxide semiconductor TFT which uses silicon nitride film as a gate insulating film.

### SUMMARY

At least one embodiment of the present disclosure provides an oxide thin film transistor, a preparation method of the oxide thin film transistor and an electronic device, the oxide thin film transistor can solve the problem of bulging of the gate insulation layer by adjusting the structure of the gate insulation layer.

At least one embodiment of the present disclosure provides an oxide thin film transistor, according to claim 1, the oxide thin film transistor includes a base substrate; a gate electrode and a metal oxide semiconductor layer that are sequentially stacked on the base substrate; a gate insulation layer provided between the metal oxide semiconductor layer and the gate electrode, the gate insulation layer comprises a silicon oxide insulation layer and a silicon nitride layer which are stacked with each other, the silicon nitride layer adopts a single-layer structure or comprises a plurality of silicon nitride sublayers that are sequentially stacked, and the silicon oxide insulation layer is between the silicon nitride layer and the metal oxide semiconductor layer; at least a part of a region in the silicon nitride layer satisfies that a percentage content of Si-H bonds in a sum of Si-N bonds, N-H bonds and Si-H bonds is not more than 7%.

For example, in the oxide thin film transistor provided by at least one embodiment of the present disclosure, at least a part of the region in the silicon nitride layer satisfies that the percentage content of the Si-H bonds in the sum of Si-N bonds, N-H bonds and Si-H bonds ranges from 0.5% to 7%.

For example, in the oxide thin film transistor provided by at least one embodiment of the present disclosure, the silicon nitride layer adopts a single-layer structure, and the percentage of the Si-H bonds in the at least a part of the region in the silicon nitride layer is positively correlated with a percentage of the Si-H in at least a part of a region in the silicon oxide insulation layer, and a stress difference between the gate electrode and the silicon nitride layer ranges from 400 Mpa to 950 Mpa, and the stress difference between the silicon nitride layer and the silicon oxide insulation layer ranges from 50 Mpa to 400 Mpa.

For example, in the oxide thin film transistor provided by at least one embodiment of the present disclosure, the silicon nitride layer comprises a first silicon nitride sublayer and a second silicon nitride sublayer which are stacked with each other, wherein the first silicon nitride sublayer is in contact with the silicon oxide insulation layer, and the second silicon nitride sublayer is on a side of the first silicon nitride sublayer away from the silicon oxide insulation layer and in contact with the gate electrode; a thickness of the second silicon nitride sublayer ranges from 2000 Å to 4800 Å, a stress of the second silicon nitride sublayer ranges from -400 Mpa to -600 Mpa, and a stress difference between the second silicon nitride sublayer and the gate electrode ranges from 670 Mpa to 870 Mpa; a thickness of the first silicon nitride sublayer ranges from 500 Å to 2000 Å, a stress of the first silicon nitride sublayer ranges from -400 Mpa to -800 Mpa, a stress difference between the first silicon nitride sublayer and the second silicon nitride sublayer ranges from 0 Mpa to 200 Mpa, a stress difference between the first silicon nitride sublayer and the silicon oxide insulation layer ranges from 50 Mpa to 400 Mpa, and a stress difference between any adjacent layers does not exceed 1000 Mpa.

For example, in the oxide thin film transistor provided by at least one embodiment of the present disclosure, thicknesses of the silicon nitride layer and the silicon oxide insulation layer are respectively represented by d1 and d2, and a thickness of the gate insulation layer is represented by d, 3500 Å < d1+d2 = d < 5000 Å, 200 Å < d2 < 2000 Å, and 4% < d2/d < 57%.

For example, in the oxide thin film transistor provided by at least one embodiment of the present disclosure, a source electrode and a drain electrode which are spaced apart from each other are on a side of the metal oxide semiconductor layer away from the base substrate, a capacitance between the metal oxide semiconductor layer and the gate electrode is represented by C, and a current between the source electrode and the drain electrode after the thin film transistor is turned on is represented by IDS, a dielectric constant of the silicon oxide insulation layer is smaller than that of the metal oxide semiconductor layer, and the thickness d2 of the silicon oxide insulation layer is inversely proportional to the current IDS in the metal oxide semiconductor layer, and the thickness d2 of the silicon oxide insulation layer is inversely proportional to the capacitance C between the metal oxide semiconductor layer and the gate electrode.

For example, in the oxide thin film transistor provided by at least one embodiment of the present disclosure, a thickness of the metal oxide semiconductor layer is represented by h, and it is satisfied that 10.8% < d2/d < 11.76%, and 3.5% < h/d < 7.4%.

For example, in the oxide thin film transistor provided by at least one embodiment of the present disclosure, a thickness of the metal oxide semiconductor layer is represented by h, and it is satisfied that 21.8% < d2/d < 37%, and 2% < h/d < 3.5%.

For example, in the oxide thin film transistor provided by at least one embodiment of the present disclosure, a thickness of the metal oxide semiconductor layer is represented by h, and it is satisfied that 21.8% < d2/d < 22.3%, and 2.5% < h/d < 2.9%.

For example, in the oxide thin film transistor provided by at least one embodiment of the present disclosure, 200 Å < d2 < 400 Å.

For example, in the oxide thin film transistor provided by at least one embodiment of the present disclosure, the oxide thin film transistor is a bottom gate type thin film transistor, and an insulating protection layer is provided on a side, of both the source electrode and the drain electrode, away from the base substrate, and the metal oxide semiconductor layer is in contact with the insulating protection layer at an interval region which is between the source electrode and the drain electrode, and the metal oxide semiconductor layer comprises a first surface and a second surface which are opposite to each other, the gate insulation layer is in contact with the first surface of the metal oxide semiconductor layer, and the insulating protection layer is in contact with the second surface of the metal oxide semiconductor layer.

For example, in the oxide thin film transistor provided by at least one embodiment of the present disclosure, the insulating protection layer comprises a first insulation layer and a second insulation layer which are stacked with each other, the second insulation layer is on a side of the first insulation layer close to the metal oxide semiconductor layer and is in contact with the metal oxide semiconductor layer, and the first insulation layer is on a side of the second insulation layer away from the metal oxide semiconductor layer and is not in contact with the metal oxide semiconductor layer; a material of the first insulation layer comprises SiNx, wherein x is greater than 0; a material of the second insulation layer comprises SiOy, wherein y is greater than 0.

For example, in the oxide thin film transistor provided by at least one embodiment of the present disclosure, the metal oxide semiconductor layer comprises a first metal oxide semiconductor layer and a second metal oxide semiconductor layer which are stacked with each other, a crystallization degree of the second metal oxide semiconductor layer is greater than that of the first metal oxide semiconductor layer, and a conductivity of the second metal oxide semiconductor layer is lower than that of the first metal oxide semiconductor layer; and the second metal oxide semiconductor layer is further away from the base substrate than the first metal oxide semiconductor layer.

For example, in the oxide thin film transistor provided by at least one embodiment of the present disclosure, a material of the first metal oxide semiconductor layer comprises at least two metal elements selected from a group consisting of indium, gallium, zinc and tin; a material of the second metal oxide semiconductor layer comprises at least two metal elements selected from the group consisting of indium, gallium, zinc and tin.

For example, in the oxide thin film transistor provided by at least one embodiment of the present disclosure, a material of the gate electrode comprises at least one selected from a group consisting of metallic elements of molybdenum, aluminum and copper, and a thickness of the gate electrode ranges from 1000 Å to 10000 Å.

At least one embodiment of the present disclosure further provides an electronic device, and the electronic device includes any one of the oxide thin film transistors in the above mentioned embodiments.

At least one embodiment of the present disclosure further provides a preparation method of an oxide thin film transistor, according to claim 12, and the preparation method includes: providing a base substrate; forming a gate electrode, a gate insulation layer and a metal oxide semiconductor layer on the base substrate, and forming the gate insulation layer comprises: forming a silicon oxide insulation layer and a silicon nitride layer, wherein the silicon nitride layer adopts a single-layer structure or comprises a plurality of silicon nitride sublayers sequentially stacked, the silicon nitride layer is formed on a side of the silicon oxide insulation layer close to the gate electrode, the silicon nitride layer is in contact with the gate electrode, and the silicon oxide insulation layer is formed on a side of the silicon nitride layer close to the metal oxide semiconductor layer, and the silicon oxide insulation layer is in contact with the metal oxide semiconductor layer, and at least a part of the region in the silicon nitride layer satisfies that a percentage content of Si-H bonds in a sum of SiN bonds, N-H bonds and Si-H bonds is not more than 7%.

For example, in the preparation method provided by at least one embodiment of the present disclosure, the silicon nitride layer adopts a single-layer structure, and an etching rate of wet etching performing on the silicon nitride layer ranges from 20 Å/s to 30 Å/s.

For example, in the preparation method provided by at least one embodiment of the present disclosure, an etching solution used for etching the silicon nitride layer is a mixed solution of NH3F and HF, and mass percentages of NH3F and HF in the mixed solution of NH3F and HF respectively range from 29.8% to 30.2% and 5.9% to 6.1%.

For example, in the preparation method provided by at least one embodiment of the present disclosure, further comprising: applying a metal electrode film on a side of the metal oxide semiconductor layer away from the base substrate, and performing a patterning process on the metal electrode film to form a source electrode and a drain electrode which are spaced apart from each other, and forming an insulating protection layer on a side, of both the source electrode and the drain electrode, away from the base substrate, wherein the metal oxide semiconductor layer is in contact with the insulating protection layer at an interval region which is between the source electrode and the drain electrode

At least one embodiment of the present disclosure further provides an oxide thin film transistor, the oxide thin film transistor includes a gate electrode, a gate insulation layer and a metal oxide semiconductor layer that are sequentially stacked on a base substrate; the gate insulation layer comprises a first insulation layer and a second insulation layer which are stacked with each other; the first gate insulation layer is located between the gate electrode and the second gate insulation layer, and the material of the first gate insulation layer includes Si element and N element, and the second gate insulation layer is located between the metal oxide semiconductor layer and the first gate insulation layer, and the material of the second gate insulation layer includes Si and O elements, the second gate insulation layer is on the side of the first gate insulation layer close to the metal oxide semiconductor layer and is in contact with the metal oxide semiconductor layer, and the first gate insulation layer is on the side of the second gate insulation layer away from the metal oxide semiconductor layer and is not in contact with the metal oxide semiconductor layer, the thicknesses of the first gate insulation layer and the second gate insulation layer are respectively represented by d₁ and d₂, and the thickness of the gate insulation layer is represented by d, it is satisfied that 3500 Å < d₁+d₂ = d < 5000 Å, and 200 Å < d₂ < 2000 Å, and 4% < d₂/d < 57%.

For example, in the oxide thin film transistor provided by at least one embodiment of the present disclosure, the oxide thin film transistor further includes a source electrode and a drain electrode, the capacitance between the metal oxide semiconductor layer and the gate electrode is represented by C, the current between the source electrode and the drain electrode is I_{DS} after the thin film transistor is turned on, the thickness d2 of the second gate insulation layer is inversely proportional to the current I_{DS}, the second gate insulation layer is a silicon oxide insulation layer, the first gate insulation layer is a silicon nitride layer, and the thickness d2 of the silicon oxide insulation layer is inversely proportional to the capacitance C between the metal oxide semiconductor layer and the gate electrode.

For example, in the oxide thin film transistor provided by at least one embodiment of the present disclosure, 5.7% < d₂/d < 40%.

For example, in the oxide thin film transistor provided by at least one embodiment of the present disclosure, the thickness of the metal oxide semiconductor layer is represented by h, and it is satisfied that 21.8% < d₂/d < 37%, and 2% < h/d < 3.5%.

For example, in the oxide thin film transistor provided by at least one embodiment of the present disclosure, the thickness of the metal oxide semiconductor layer is represented by h, and it is satisfied that 21.8% < d₂/d < 22.3%, and 2.5% < h/d < 2.9%.

For example, in the oxide thin film transistor provided by at least one embodiment of the present disclosure, it is satisfied that 200 Å < d₂ < 400 Å.

For example, in the oxide thin film transistor provided by at least one embodiment of the present disclosure, the metal oxide semiconductor layer adopts a single-layer structure or a stacked structure constituted by a plurality of sublayers.

For example, in the oxide thin film transistor provided by at least one embodiment of the present disclosure, the metal oxide semiconductor layer adopts a stacked structure constituted by a plurality of sublayers, and the metal oxide semiconductor layer includes a first metal oxide semiconductor layer and a second metal oxide semiconductor layer which are stacked with each other, the compactness of the first metal oxide semiconductor layer is greater than that of the second metal oxide semiconductor layer, and the second metal oxide semiconductor layer is arranged on the side of the first metal oxide semiconductor layer close to the base substrate and is in contact with the second gate insulation layer.

For example, in the oxide thin film transistor provided by at least one embodiment of the present disclosure, the material of the metal oxide semiconductor layer includes at least one selected from a group consisting of indium gallium zinc oxide, indium gallium zinc oxide containing Sn and lanthanide metal oxide.

For example, in the oxide thin film transistor provided by at least one embodiment of the present disclosure, the mobility of the metal oxide semiconductor layer ranges from 5 cm²/vs to 50 cm²/v•s.

For example, in the oxide thin film transistor provided by at least one embodiment of the present disclosure, the oxide thin film transistor is a bottom gate type thin film transistor, and the oxide thin film transistor further includes a passivation layer arranged on the side, of both the source electrode and the drain electrode, away from the base substrate, the metal oxide semiconductor layer includes a first surface and a second surface which are opposite to each other, and the second gate insulation layer is in contact with the first surface of the metal oxide semiconductor layer, and the passivation layer is in contact with the second surface of the metal oxide semiconductor layer.

For example, in the oxide thin film transistor provided by at least one embodiment of the present disclosure, the passivation layer includes a first passivation layer and a second passivation layer which are stacked with each other, and the material of the first passivation layer includes SiNx and does not include oxygen, in which x is greater than 0; the material of the second passivation layer includes SiOy, in which y is greater than 0; the second passivation layer is on the side of the first passivation layer close to and is in contact with the metal oxide semiconductor layer, and the first passivation layer is on the side of the second passivation layer away from the metal oxide semiconductor layer and is not in contact with the metal oxide semiconductor layer.

### BRIEF DESCRIPTION OF DRAWINGS

In order to clearly illustrate the technical solution of the embodiments of the present disclosure, the drawings of the embodiments will be briefly described. It is obvious that the described drawings in the following are only related to some embodiments of the present disclosure and thus are not limitative of the present disclosure.
FIG. 1 is a schematic cross-sectional structural view of an oxide thin film transistor provided by an embodiment of the present disclosure;
FIG. 2 is a schematic cross-sectional structural view of another oxide thin film transistor provided by an embodiment of the present disclosure;
FIG. 3 is a schematic cross-sectional structural view of further another oxide thin film transistor provided by an embodiment of the present disclosure;
FIG. 4 is a schematic cross-sectional structural view of further another oxide thin film transistor provided by an embodiment of the present disclosure;
FIG. 5 is a schematic cross-sectional structural view of further another oxide thin film transistor provided by an embodiment of the present disclosure;
FIG. 6 is a flowchart of a preparation method of a thin film transistor provided by an embodiment of the present disclosure; and
FIG. 7 is a schematic cross-sectional structural view of another oxide thin film transistor provided by an embodiment of the present disclosure.

### DETAILED DESCRIPTION

In order to make objects, technical details and advantages of the embodiments of the disclosure apparent, the technical solutions of the embodiments will be described in a clearly and fully understandable way in connection with the drawings related to the embodiments of the disclosure. Apparently, the described embodiments are just a part but not all of the embodiments of the disclosure. Based on the described embodiments herein, those skilled in the art can obtain other embodiment (s), without any inventive work, which should be within the scope of the disclosure.

Unless otherwise defined, all the technical and scientific terms used herein have the same meanings as commonly understood by one of ordinary skill in the art to which the present disclosure belongs. The terms "first," "second," etc., which are used in the description and the claims of the present application for disclosure, are not intended to indicate any sequence, amount or importance, but distinguish various components. Also, the terms "comprise," "comprising," "include," "including," etc., are intended to specify that the elements or the objects stated before these terms encompass the elements or the objects and equivalents thereof listed after these terms, but do not preclude the other elements or objects. The phrases "connect", "connected", etc., are not intended to define a physical connection or mechanical connection, but may include an electrical connection, directly or indirectly. "On," "under," "left," "right" and the like are only used to indicate relative position relationship, and when the position of the object which is described is changed, the relative position relationship may be changed accordingly.

Compared with silicon-based semiconductor thin film transistors and organic semiconductor thin film transistors, oxide semiconductor thin film transistors are becoming more and more important in the high-end display field because of the higher mobility thereof. With the gradual development of electronic products, the development of high mobility oxide thin film transistors has become the focus of research and development of various display panel manufacturers. However, with the improvement of the mobility of oxide semiconductor thin film transistors, the requirements for the stability of oxide semiconductor thin film transistors are getting higher and higher.

The internal stress of a SiOx thin film made of silicon and oxygen generally has larger negative stress, for example, is about -350 Mpa, while the stress of the thin film made of Cu as electrode material generally has positive stress, for example, is about 300 Mpa. It can be seen that there is a large stress difference between the electrode made of the metal material Cu and the insulation layer made of the material SiOx, moreover, the electrode made of the metal material Cu and the insulation layer made of the material SiOx are mainly connected by van der Waals force, and the adhesion between the two is poor. In actual production, poor bulging often occurs between the electrode made of the metal material Cu and the insulation layer made of the material SiOx. In addition, in the case that the metal oxide is used to form the active layer and the insulation layer which is subsequently formed, a high-temperature process is generally adopted, which will make Cu grow into the insulation layer to form copper whiskers and break through the insulation layer, so that the insulating function of the insulation layer disappears, resulting in poor short circuit, which will seriously affect the yield of products.

The inventors of the present disclosure have noticed that the binding capacity of Si-N bond is higher than that of Si-H bond, and the binding capacity of Si-O-Si bond is also higher than that of Si-H-Si bond. The bonding force between the Si-N bond and the Cu metal layer is stronger than that between the Si-H bond and the Cu metal layer. Moreover, in the subsequent high-temperature annealing process, compared with O element, H element is easier to break away and escape. The less the percentage of Si-H bonds in the film formed by the SiNx material, it shows that the more the number of Si-N bonds, the less the overflow of H element during the annealing process, the stronger the binding ability between adjacent films, and the higher the adhesion between the adjacent films, and the lower the probability of bulging between the adjacent films. For example, a large number of layers made of silicon nitride in the gate insulation layer may lead to mass production failure, and a small number of layers may lead to stress mismatch, which may lead to the problem of bulging, thus affecting the yield of thin film transistors and making gate lines and data lines easily short-circuited. Based on the above considerations, the inventors of the present disclosure have made improvements in balancing mass production and reducing bulging to improve yield.

At least one embodiment of the present disclosure provides an oxide thin film transistor, the oxide thin film transistor comprises: a base substrate, a gate electrode and a metal oxide semiconductor layer that are sequentially stacked on the base substrate, a gate insulation layer provided between the metal oxide semiconductor layer and the gate electrode; the gate insulation layer comprises a silicon oxide insulation layer and a silicon nitride layer which are stacked with each other, the silicon nitride layer adopts a single-layer structure or comprises a plurality of silicon nitride sublayers that are sequentially stacked, and the silicon oxide insulation layer is between the silicon nitride layer and the metal oxide semiconductor layer; at least a part of a region in the silicon nitride layer satisfies that a percentage content of Si-H bonds in a sum of Si-N bonds, N-H bonds and Si-H bonds is not more than 7%.

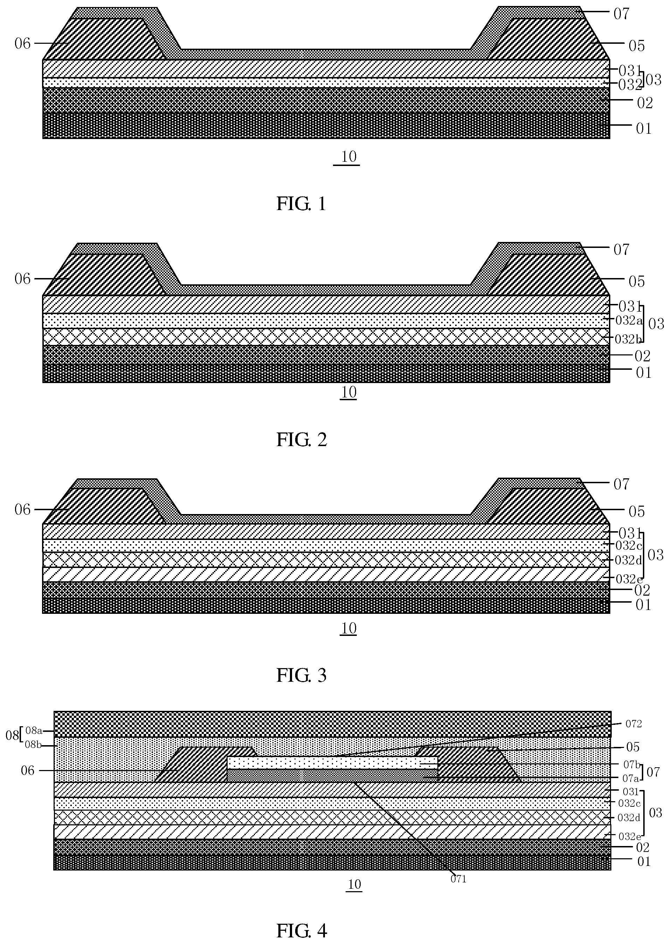

For example, FIG. 1 is a schematic cross-sectional structural view of an oxide thin film transistor provided by an embodiment of the present disclosure. As shown in FIG. 1, the oxide thin film transistor 10 includes a base substrate 01, a gate electrode 02 and a metal oxide semiconductor layer 07 that are sequentially stacked on the base substrate 01, a gate insulation layer 03 arranged between the metal oxide semiconductor layer 07 and the gate electrode 02; the gate insulation layer 03 comprises a silicon oxide insulation layer 031 and a silicon nitride layer 032 which are stacked with each other, the silicon nitride layer 032 adopts a single-layer structure, and the silicon oxide insulation layer 031 is arranged between the silicon nitride layer 032 and the metal oxide semiconductor layer 07; there are at least a part of a region in the silicon nitride layer 032 satisfying that the percentage of silicon hydrogen bonds (Si-H bonds) in the sum of silicon nitrogen bonds (Si-N bonds), nitrogen hydrogen bonds (N-H bonds) and silicon hydrogen bonds (Si-H bonds) in the at least a part of a region is not more than 7%.

For example, the base substrate 01 is formed of a rigid material or a flexible material. For example, the rigid material includes one selected from a group consisting of a rigid glass and a silicon wafer. The flexible material includes one selected from a group consisting of polyethylene naphthalate, polyethylene terephthalate, polyimide and flexible glass.

For example, in one example, the material of the gate electrode 02 includes at least one selected from a group consisting of molybdenum, aluminum and copper, and the thickness of the gate electrode ranges from 1000 Å to 10000 Å.

For example, in another example, the material of the gate electrode 02 may be copper metal, or a combination of copper metal and other metals, for example, copper/molybdenum (Cu/Mo), copper/titanium (Cu/Ti), copper/molybdenum titanium alloy (Cu/MoTi), copper/molybdenum tungsten alloy (Cu/MoW) and copper/molybdenum niobium alloy (Cu/MoNb), etc. The material of the gate electrode 02 may also be a chromium-based metal or a combination of chromium and other metals, for example, chromium/molybdenum (Cr/Mo), chromium/titanium (Cr/Ti), chromium/molybdenum titanium alloy (Cr/MoTi), etc. In the following embodiments, the technical scheme is described by taking the case that the material of the gate electrode 02 is copper as an example.

For example, the metal oxide semiconductor layer 07 may adopts a single-layer structure or a double-layer structure. For example, the metal oxide semiconductor layer 07 adopts a double-layer structure, and the metal oxide semiconductor layer includes a first metal oxide semiconductor layer and a second metal oxide semiconductor layer that are stacked with each other, and the second metal oxide semiconductor layer is further away from the gate insulation layer 03 relative to the first metal oxide semiconductor layer, and the compactness of the second metal oxide semiconductor layer is greater than that of the first metal oxide semiconductor layer.

For example, the material of the metal oxide semiconductor layer 07 includes at least one selected from the n-type semiconductor materials consisting of zinc oxide (ZnO), indium oxide (In₂O₃), indium zinc oxide (HIZO), aluminum-doped zinc oxide (AZO), boron-doped zinc oxide (BZO), magnesium-doped zinc oxide (MZO), tin zinc oxide (ZTO), indium gallium zinc oxide (IGZO), indium tin zinc oxide (ITZO), gallium zinc oxide (GZO), indium tin oxide (ITO), hafnium indium zinc oxide (HIZO) and tin oxide (SnO₂), etc., and includes at least one selected from p-type semiconductor materials consisting of stannous oxide (SnO) and cuprous oxide (Cu₂O).

For example, the metal oxide semiconductor layer 07 may be formed by a method such as magnetron sputtering, reactive sputtering, anodic oxidation or spin coating.

It should be noted that a certain amount of nitrogen also exists in the silicon oxide insulation layer 031. It is clear to those skilled in the art that the actually prepared silicon oxide insulation layer 031 contains a certain amount of N element, because it is necessary to use a gas component containing N element when making the silicon oxide, and a certain amount of N element inevitably exists in the silicon oxide insulation layer. For example, the silicon oxide insulation layer may be formed by reacting silane with nitrous oxide. Silicon nitride is formed by the reaction of silane and ammonia. According to the different reaction raw materials, the percentage of silicon hydrogen bonds in the formed silicon oxide insulation layer 031 and silicon nitride layer 032 can be controlled.

For example, the silicon oxide insulation layer 031 is disposed between the silicon nitride layer 032 and the metal oxide semiconductor layer 07, so that the silicon oxide insulation layer 031 separates the metal oxide semiconductor layer 07 from the silicon nitride layer 032, thereby reducing the risk of allowing the hydrogen in the silicon nitride layer 032 to enter the metal oxide semiconductor layer 07.

For example, by adjusting the molar ratio of silane to nitrous oxide, the power of the reaction chamber, the air pressure, etc. during the reaction of silane and nitrous oxide, the formed silicon oxide insulation layer 031 can have different densities, and the smaller the molar ratio of Si:O in the silicon oxide insulation layer 031, the greater the density of the formed silicon oxide insulation layer 031. The greater the density of the silicon oxide insulation layer, the more difficult it is for the etching solution used in the patterning process to enter the silicon oxide insulation layer 031, thus preventing the etching solution from entering the metal oxide semiconductor layer 07, that is, reducing the risk of damage to the metal oxide semiconductor layer 07.

For example, there are at least a part of the region in the silicon nitride layer 032 satisfying that the percentage of silicon hydrogen bonds (Si-H bonds) in the sum of silicon nitrogen bonds (Si-N bonds), nitrogen hydrogen bonds (N-H bonds) and silicon hydrogen bonds (Si-H bonds) in at least a part of the region is not more than 7%, because the chemical binding ability of the Si-H bond is lower than that of the Si-N bond, and the binding force between the Si-H bond and the Cu metal is weaker than that between the Si-N bond and the Cu metal. During the subsequent high temperature annealing process, H atoms are easier to break away and escape than O atoms. If the percentage of silicon-hydrogen bond (Si-H bond) in the sum of silicon-nitrogen bond (Si-N bond), nitrogen-hydrogen bond (N-H bond) and silicon-hydrogen bond (Si-H bond) is more than 7%, more H element will escape during subsequent annealing process, and thus the binding force between adjacent films will be weaker, and the adhesion between adjacent films will be weaker, thereby the probability of bulging between films will be higher, and in the scheme that the percentage content of silicon hydrogen bond (Si-H bond) is controlled to be no more than 7%, the operation process is simple and convenient, thus saving the equipment cost and the process cost.

For example, there are at least a part of a region in the silicon oxide insulation layer 031 satisfying that the percentage of silicon hydrogen bonds (Si-H bonds) in the sum of silicon oxygen bonds (Si-O bonds), nitrogen hydrogen bonds (N-H bonds) and silicon hydrogen bonds (Si-H bonds) in the at least a part of the region ranges from 0.1% to 15%, which can make the H element escape less during subsequent annealing and ensure the binding force between adjacent layers, and the probability of bulging phenomenon between the layers is reduced; in addition, in the scheme that the percentage content of silicon hydrogen bond (Si-H bond) in the silicon oxide insulation layer 031 is controlled to be no more than 15%, the operation process is simple and convenient, thus saving the equipment cost and the process cost.

For example, in one example, there are at least a part of a region in the silicon nitride layer 032 satisfying that the percentage of silicon hydrogen bonds (Si-H bonds) in the at least a part of the region ranges from 0.5% to 7% of the sum of Si-N bonds, N-H bonds and Si-H bonds. For example, if the content of NH₃ in the reaction gas used is too small when the silicon nitride layer 032 is formed, the percentage of the Si-N bonds cannot be ensured.

For example, in one example, the silicon nitride layer 032 adopts a single-layer structure, and the percentage of silicon hydrogen bonds in at least a part of the region in the silicon nitride layer 032 is positively correlated with the percentage of silicon hydrogen bonds in at least a part of a region in the silicon oxide insulation layer 031, that is, the higher the percentage of silicon hydrogen bonds in the at least a part of the region in the silicon nitride layer 032, the higher the percentage of silicon hydrogen bonds in the at least a part of the region in the silicon oxide insulation layer 031. And the stress difference between the gate electrode 02 and the silicon nitride layer 032 ranges from 400 Mpa to 950 Mpa, for example, the stress difference between the gate electrode 02 and the silicon nitride layer 032 may be any one selected from a group consisting of 400 Mpa, 450 Mpa, 500 Mpa, 550 Mpa, 600 Mpa, 650 Mpa, 700 Mpa, 750 Mpa, 800 Mpa, 850 Mpa, 900 Mpa and 950 Mpa, etc. For example, by a single film test, the stress of the gate electrode 02 ranges from 150 Mpa to 350 Mpa, and the stress of the silicon nitride layer 032 ranges from - 250 Mpa to -850 Mpa.

For example, the stress difference between the silicon nitride layer 032 and the silicon oxide insulation layer 031 ranges from 50 Mpa to 400 Mpa. For example, the stress difference between the silicon nitride layer 032 and the silicon oxide insulation layer 031 may be any one selected from a group consisting of 50 Mpa, 80 Mpa, 130 Mpa, 150 Mpa, 190 Mpa, 240 Mpa, 300 Mpa, 350 Mpa, 380 Mpa and 400 Mpa. For example, the stress of the silicon oxide insulation layer 031 ranges from -200 Mpa to -400 Mpa through a single film test.

For example, FIG. 2 is a schematic cross-sectional structural diagram of another oxide thin film transistor provided by an embodiment of the present disclosure. As shown in FIG. 2, the silicon nitride layer 032 includes a first silicon nitride sublayer 032a and a second silicon nitride sublayer 032b which are stacked with each other, the first silicon nitride sublayer 032a is in contact with the silicon oxide insulation layer 031, and the second silicon nitride sublayer 032b is arranged on a side of the first silicon nitride sublayer 032a away from the silicon oxide insulation layer 031 and is in contact with the gate electrode 02. The thickness of the second silicon nitride sublayer 032b ranges from 2000 Å to 4800 Å, the stress of the second silicon nitride sublayer 032b ranges from -400 Mpa to -600 Mpa, and the stress difference between the second silicon nitride sublayer 032b and the gate electrode 02 ranges from 670 Mpa to 870 Mpa; the thickness of the first silicon nitride sublayer 032a ranges from 500 Å to 2000 Å, the stress of the first silicon nitride sublayer 032a ranges from -400 Mpa to -800 Mpa, and the stress difference between the first silicon nitride sublayer 032a and the second silicon nitride sublayer 032b ranges from 0 Mpa to 200 Mpa, and the stress difference between the first silicon nitride sublayer 032a and the silicon oxide insulation layer 031 ranges from 50 Mpa to 400 Mpa, and the stress difference between any two adjacent layers does not exceed 1000 Mpa.

For example, the second silicon nitride sublayer 032b is equivalent to a buffer layer. The content of hydrogen element in the first silicon nitride sublayer 032a is smaller than that in the second silicon nitride sublayer 032b, which can reduce the risk of oxidation of the gate electrode 02 and reduce the risk of reduction of the metal oxide semiconductor layer 07.

For example, the value of stress difference between every two adjacent layers does not exceed 1000 Mpa, so as to ensure that the internal stress after performing the annealing process is small and reduce the risk of warping of the layers.

For example, FIG. 3 is a schematic cross-sectional structural view of another oxide thin film transistor provided by an embodiment of the present disclosure, as shown in FIG. 3, the silicon nitride layer includes a third silicon nitride sublayer 032c, a fourth silicon nitride sublayer 032d and a fifth silicon nitride sublayer 032e which are stacked, the third silicon nitride sublayer 032c is in contact with the oxide insulation layer 031, and the fifth silicon nitride sublayer 032e is arranged on the side of the third silicon nitride sublayer 032c away from the oxide insulation layer 031, and the fourth silicon nitride sublayer 032d is sandwiched between the third silicon nitride sublayer 032c and the fifth silicon nitride sublayer 032e.

For example, the fifth silicon nitride sublayer 032e is equivalent to a buffer layer on the side close to the gate electrode 02, the fourth silicon nitride sublayer 032d is a silicon nitride layer deposited at a high speed, and the third silicon nitride sublayer 032c is a silicon nitride layer deposited at a low speed.

For example, the thickness of the fifth silicon nitride sublayer 032e ranges from 2000 Å to 4800 Å, and the stress of the fifth silicon nitride sublayer 032e ranges from -600 Mpa to -1000 MPa; the thickness of the fourth silicon nitride sublayer 032d ranges from 2000 Å to 4000 Å, and the stress of the fourth silicon nitride sublayer 032d ranges from 150 Mpa to 400 Mpa; the thickness of the third silicon nitride sublayer 032c ranges from 500 Å to 2000 Å, and the stress of the third silicon nitride sublayer 032c ranges from -400 Mpa to -800 Mpa. The value of stress difference between every two adjacent layers can be less than 1000 Mpa, which can be realized by the silicon nitride with of the stacked structure including three sublayers, so as to ensure that the internal stress is small after performing the annealing process and reduce the risk of warping of the layers.

For example, in one example, the thicknesses of the silicon nitride layer 032 and the silicon oxide insulation layer 031 are respectively represented by d₁ and d₂, and the thickness of the gate insulation layer 03 is represented by d, it is satisfied that 3500 Å < d₁+d₂ = d < 5000 Å, and 200 Å < d₂ < 2000 Å, and 4% < d₂/d < 57%. The ratio of the thickness d₂ of the silicon oxide insulation layer 031 to the thickness d of the gate insulation layer 03 is greater than 4%, which can ensure the uniformity of each layer in the whole oxide thin film transistor. If the thickness d₂ of the silicon oxide insulation layer 031 is too thin, for example, less than 10nm, used as the interface transition layer between the silicon nitride layer 032 and the metal oxide semiconductor layer 07, it may expose the underlying silicon nitride layer 032, resulting in the contact between the silicon nitride layer 032 and the metal oxide semiconductor layer 07. If the thickness d₂ of the silicon oxide insulation layer 031 is too large, it will not be beneficial to improving the productivity, and it will also lead to a small on-state current. The ratio of the thickness d₂ of the silicon oxide insulation layer 031 to the thickness d of the gate insulation layer 03 within the above range can give consideration to both the productivity and the on-state current Iₒₙ, so that the on-state current Iₒₙ can be of an appropriate value.

For example, with reference to figs. 1 to 3, a source electrode 05 and a drain electrode 06 that are spaced apart from each other are arranged on the side of the metal oxide semiconductor layer 07 away from the base substrate 01, the capacitance between the metal oxide semiconductor layer 07 and the gate electrode 02 is represented by C, the current between the source electrode 05 and the drain electrode 06 is I_{DS} after the thin film transistor is turned on, and the dielectric constant of the silicon oxide insulation layer 031 is smaller than that of the metal oxide semiconductor layer 07. The thickness d₂ of the silicon oxide insulation layer 032 is inversely proportional to the current I_{DS} in the metal oxide semiconductor layer 07, and the thickness d₂ of the silicon oxide insulation layer 032 is inversely proportional to the capacitance C between the metal oxide semiconductor layer 07 and the gate electrode 02.

For example, it is satisfied that I_{DS}= W/L*A/((d-d₂)ε₂+d₂ε₁) (Vgs-Vth-Vds/2)Vds, and d₁+d₂=d, in which d represents the total thickness of the gate insulation layer 03, the thickness of the silicon nitride layer 032 is represented by d₂, and the thickness of the silicon oxide insulation layer 031 is represented by d₁. The smaller d₂ is, the greater the current between the source electrode 05 and the drain electrode 06 is, after the thin film transistor is turned on.

For example, the capacitor C=ε₀ε₁*ε₂/4πk (d₁ε₂+d₂ε₁) = ε₀ε₁*ε₂/4πk ((d-d₂) ε₂+d₂ε₁)=ε₀ε₁*ε₂/4πk ((dε₂+d₂(ε₁-ε₂)), in which ε₁ represents the dielectric constant of SiNx in the silicon nitride layer, and ε₂ represents the dielectric constant of SiOx in the silicon oxide insulation layer; ε₁>ε₂; the smaller d₂ is, the larger the capacitance C is.

For example, etching time for gate insulation layer 03 is represented by T, it is satisfied that T=d₂/R₁+(d-d₂)/R₂=d/R₂+d₂ ( R₂-R₁ ) /R₂R₁, in which R₁ represents the etching rate of the silicon nitride layer, R₂ represents the etching rate of the silicon oxide insulation layer, and R₁>R₂, that is, it can be satisfied that the smaller d₂ is, the greater T is.

For example, in one example, the thickness of the metal oxide semiconductor layer 07 is represented by h, and it is satisfied that 10.8% < d₂/d < 11.76%, and 3.5% < h/d < 7.4%.

For example, in one example, the thickness of the metal oxide semiconductor layer is represented by h, and it is satisfied that 21.8% < d₂/d < 37%, and 2% < h/d < 3.5%.

For example, in one example, the thickness of the metal oxide semiconductor layer is represented by h, and it is satisfied that 21.8% < d₂/d < 22.3%, and 2.5% < h/d < 2.9%.

For example, the thickness d₂ of the silicon oxide insulation layer 031 satisfies 200 Å < d₂ < 400 Å. Preparing the silicon oxide insulation layer 031 to have a thickness in this size range can make the current I_{DS} in the metal oxide semiconductor layer larger and the capacitance C between the metal oxide semiconductor layer 07 and the gate electrode 02 larger.

For example, FIG. 4 is a schematic cross-sectional structural view of further another oxide thin film transistor provided by an embodiment of the present disclosure, as shown in FIG. 4, the oxide thin film transistor 10 is a bottom gate type thin film transistor, and an insulating protection layer 08 is provided on the side of the source electrode 05 and the drain electrode 06 away from the base substrate 01, and the metal oxide semiconductor layer 07 is in contact with the insulating protection layer 08 at an interval region which is between the source electrode 05 and the drain electrode 06, and the metal oxide semiconductor layer 07 includes a first surface 071 and a second surface 072 that are opposite to each other. The gate insulation layer 02 is in contact with the first surface 071 of the metal oxide semiconductor layer 07, and the insulating protection layer 08 is in contact with the second surface 072 of the metal oxide semiconductor layer 07. The insulating protection layer 08 can prevent external water vapor from entering the metal oxide semiconductor layer 07 and affecting the performance of the metal oxide semiconductor layer 07.

For example, as shown in FIG. 4, the insulating protection layer 08 includes a first insulation layer 08a and a second insulation layer 08b which are stacked with each other. The second insulation layer 08b is on the side of the first insulation layer 08a close to the metal oxide semiconductor layer 07 and is in contact with the metal oxide semiconductor layer 07, and the first insulation layer 08a is on the side of the second insulation layer 08b away from the metal oxide semiconductor layer 07 and is not in contact with the metal oxide semiconductor layer 07. For example, the material of the first insulation layer 08a includes SiNx, in which x is greater than 0; the material of the second insulation layer 08b includes SiOy, in which y is greater than 0.

It should be noted that the compactness of the first insulation layer 08a refers to the degree of difficulty for liquid or gas to enter the first insulation layer 08a from the outside, and the greater the compactness of the first insulation layer 08a, the more difficult or impossible it is for liquid or gas to enter the first insulation layer 08a from the outside. The compactness of the second insulation layer 08b refers to the degree of difficulty for liquid or gas to enter the second insulation layer 08b from the outside, and the greater the compactness of the second insulation layer 08b, the more difficult it is for liquid or gas to enter the second insulation layer 08b from the outside, or the liquid or gas cannot at all enter the second insulation layer 08b from the outside.

For example, as shown in FIG. 4, the metal oxide semiconductor layer 07 includes a first metal oxide semiconductor layer 07a and a second metal oxide semiconductor layer 07b which are stacked with each other, the crystallization degree of the second metal oxide semiconductor layer 07b is greater than that of the first metal oxide semiconductor layer 07a, and the conductivity of the second metal oxide semiconductor layer 07b is lower than that of the first metal oxide semiconductor layer 07a; and the second metal oxide semiconductor layer 07b is further away from the base substrate 01 than the first metal oxide semiconductor layer 07a. For example, the first metal oxide semiconductor layer 07a serves as the channel region, and the second metal oxide semiconductor layer 07b can protect the first metal oxide semiconductor layer 07a.

For example, the material of the first metal oxide semiconductor layer 07a includes at least two metal elements selected from a group consisting of indium, gallium, zinc and tin, and the material of the second metal oxide semiconductor layer 07b includes at least two metal elements selected from the group consisting of indium, gallium, zinc and tin. For example, in one example, the material of the first metal oxide semiconductor layer 07a and the material of the second metal oxide semiconductor layer 07b may both be indium gallium zinc oxide (IGZO), and the second metal oxide semiconductor layer 07b and the first metal oxide semiconductor layer 07a may have different degrees of crystallization according to different formation conditions in the preparation process of the two.

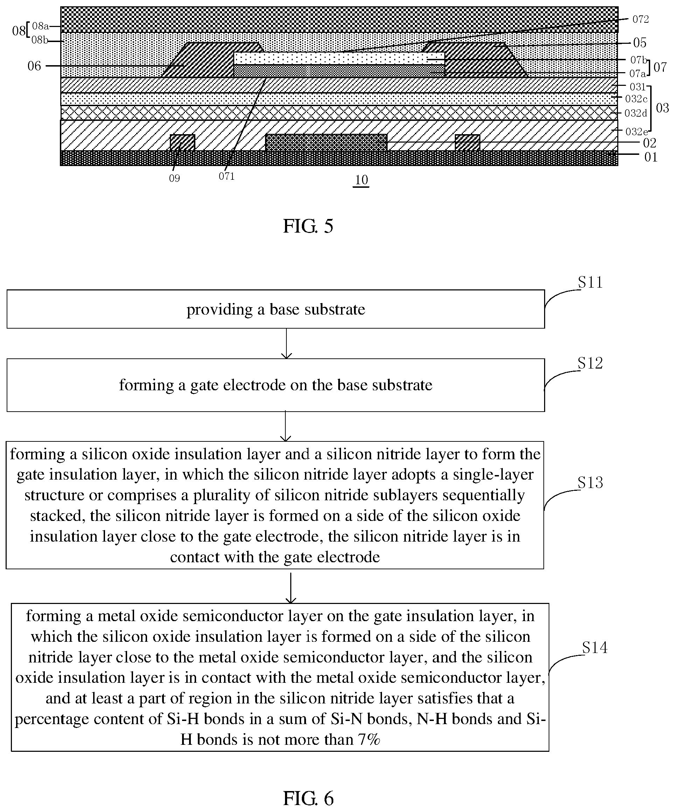

For example, FIG. 5 is a schematic cross-sectional structural view of another oxide thin film transistor provided by an embodiment of the present disclosure. The difference between FIG. 5 and FIG. 4 is that in FIG. 5, the oxide thin film transistor further includes an electrode layer 09, the electrode layer may be a common electrode. For example, the material of the electrode layer 09 includes indium tin oxide, or indium zinc oxide or the like. For example, in the case where the material of the electrode layer 09 is indium tin oxide, by single-layer film testing, the stress of the electrode layer 09 ranges from -200 Mpa to -400 Mpa, the thickness of the fifth silicon nitride sublayer 032e in contact with the electrode layer 09 ranges from 2000 Å to 4800 MPa Å, and the stress of the fifth silicon nitride sublayer 032e ranges from -600 Mpa to -1000 Mpa, in this way, the stress difference between the electrode layer 09 and the fifth silicon nitride sublayer 032e can range from 200 Mpa to 800 Mpa, so that the phenomenon of bulging is not easy to occur.

At least one embodiment of the present disclosure further provides an electronic device, the electronic device includes the oxide thin film transistor in any one of the above embodiments. For example, the electronic device may be a display device or a semiconductor chip, and the display device may also be a liquid crystal display panel, an organic light emitting diode display panel, a micro light emitting diode display panel, an X-ray sensing array and other devices that need to be provided with a thin film transistor.

At least one embodiment of the present disclosure further provides a preparation method of an oxide thin film transistor, the preparation method comprises: providing a base substrate; forming a gate electrode, a gate insulation layer and a metal oxide semiconductor layer on the base substrate, in which forming the gate insulation layer comprises: forming a silicon oxide insulation layer and a silicon nitride layer, the silicon nitride layer is formed on a side of the silicon oxide insulation layer close to the gate electrode, the silicon nitride layer is in contact with the gate electrode, and the silicon oxide insulation layer is formed on a side of the silicon nitride layer close to the metal oxide semiconductor layer, and the silicon oxide insulation layer is in contact with the metal oxide semiconductor layer, and at least a part of a region in the silicon nitride layer satisfies that a percentage content of Si-H bonds in a sum of Si-N bonds, N-H bonds and Si-H bonds is not more than 7%.

FIG. 6 is a flowchart of a preparation method of a thin film transistor provided by an embodiment of the present disclosure, as shown in FIG. 6, the preparation method comprises the following steps:
S11. providing a base substrate;
S12. forming a gate electrode on the base substrate;
S13. forming a silicon oxide insulation layer and a silicon nitride layer to form the gate insulation layer, in which the silicon nitride layer adopts a single-layer structure or comprises a plurality of silicon nitride sublayers sequentially stacked, the silicon nitride layer is formed on a side of the silicon oxide insulation layer close to the gate electrode, the silicon nitride layer is in contact with the gate electrode;
S14. forming a metal oxide semiconductor layer on the gate insulation layer, in which the silicon oxide insulation layer is formed on a side of the silicon nitride layer close to the metal oxide semiconductor layer, and the silicon oxide insulation layer is in contact with the metal oxide semiconductor layer, and at least a part of the region in the silicon nitride layer satisfies that a percentage content of Si-H bonds in a sum of Si-N bonds, N-H bonds and Si-H bonds is not more than 7%.

For example, the material, thickness, stress and other characteristics of the gate electrode, the gate insulation layer formed by the silicon oxide insulation layer and the silicon nitride layer, and the metal oxide semiconductor layer can be referred to the above-mentioned related descriptions, and will not be repeated herein.

For example, the silicon nitride layer adopts a single-layer structure, and the etching rate of wet etching performing on the silicon nitride layer ranges from 20 Å/s to 30 Å/s, for example, the etching rate is 20 Å /s, 24 Å /s, 25 Å /s, 28 Å /s or 30 Å/s. The related characteristics of the silicon nitride layer with the single-layer structure can be found in the above-mentioned related descriptions, and will not be repeated here.

For example, an etching solution used for etching the silicon nitride layer is a mixed solution of NH3F and HF, and mass percentages of NH3F and HF in the mixed solution of NH3F and HF respectively range from 29.8% to 30.2% and 5.9% to 6.1%. The remaining components in the etching solution may be deionized water.

For example, on the basis of the flowchart shown in Figure 6, the preparation method further includes: applying a metal electrode film on a side of the metal oxide semiconductor layer away from the base substrate, and performing a patterning process on the metal electrode film to form a source electrode and a drain electrode which are spaced apart from each other, and forming an insulating protection layer on a side, of both the source electrode and the drain electrode, away from the base substrate, in which the metal oxide semiconductor layer is in contact with the insulating protection layer at an interval region which is between the source electrode and the drain electrode.

For example, the related descriptions of the source electrode, the drain electrode and the insulating protection layer can be found in the above related descriptions, which are not repeated herein.

For example, in the case where the metal oxide semiconductor layer adopts a double-layered structure, forming the metal oxide semiconductor layer includes: applying a first metal oxide semiconductor layer thin film and performing a patterning process on the first metal oxide semiconductor layer thin film to form the first metal oxide semiconductor layer; applying a second metal oxide semiconductor layer thin film on the first metal oxide semiconductor layer and performing a patterning process on the second metal oxide semiconductor layer thin film to form the second metal oxide semiconductor layer; and the compactness of the second metal oxide semiconductor layer is greater than that of the first metal oxide semiconductor layer.

For example, the silicon nitride layer includes a first silicon nitride sublayer and a second silicon nitride sublayer which are stacked with each other, the first silicon nitride sublayer is in contact with the silicon oxide insulation layer, and the second silicon nitride sublayer is arranged on the side of the first silicon nitride sublayer away from the silicon oxide insulation layer and is in contact with the gate electrode.

For example, the thickness of the second silicon nitride sublayer is ranges from 2000 Å to 4800 Å, the stress of the second silicon nitride sublayer ranges from -400 Mpa to -600 Mpa, and the stress difference between the second silicon nitride sublayer and the gate electrode ranges from 670 Mpa to 870 Mpa; the thickness of the first silicon nitride sublayer ranges from 500 Å to 2000 Å, the stress of the first silicon nitride sublayer ranges from -400 Mpa to 800 MPa, and the stress difference between the first silicon nitride sublayer and the second silicon nitride sublayer ranges from 0 Mpa to 200 Mpa, and the stress difference between the first silicon nitride sublayer and the silicon oxide insulation layer ranges from 50 Mpa to 400 Mpa, and the stress difference between any adjacent layers does not exceed 1000 Mpa.

For example, the silicon nitride layer may include a third silicon nitride sublayer, a fourth silicon nitride sublayer and a fifth silicon nitride sublayer that are stacked, the third silicon nitride sublayer is in contact with the silicon oxide insulation layer, and the fifth silicon nitride sublayer is arranged on the side of the third silicon nitride sublayer away from the silicon oxide insulation layer, and the fourth silicon nitride sublayer is sandwiched between the third silicon nitride sublayer and the fifth silicon nitride sublayer. For example, the thickness of the fifth silicon nitride sublayer ranges from 2000 Å to 4800 Å, and the stress of the fifth silicon nitride sublayer ranges from -600 Mpa to -1000 MPa; the thickness of the fourth silicon nitride sublayer ranges from 2000 Å to 4000 Å, and the stress of the fourth silicon nitride sublayer ranges from 150 Mpa to 400 Mpa; the thickness of the third silicon nitride sublayer ranges from 500 Å to 2000 Å, and the stress of the third silicon nitride sublayer ranges from -400Mpa to -800Mp.

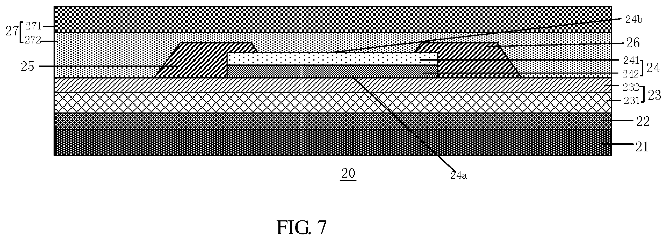

At least one embodiment of the present disclosure further provides an oxide thin film transistor. For example, FIG. 7 is a schematic cross-sectional structural view of further another oxide thin film transistor provided by an embodiment of the present disclosure. As shown in FIG. 7, the oxide thin film transistor 20 includes a gate electrode 22, a gate insulation layer 23 and a metal oxide semiconductor layer 24 that are stacked on a base substrate 21, the gate insulation layer 23 includes a first gate insulation layer 231 and a second gate insulation layer 232 that are stacked with each other; the first gate insulation layer 231 is located between the gate electrode 22 and the second gate insulation layer 232, and the material of the first gate insulation layer 231 includes Si element and N element, and the second gate insulation layer 232 is located between the metal oxide semiconductor layer 24 and the first gate insulation layer 231, and the material of the second gate insulation layer 232 includes Si and O elements. The second gate insulation layer 232 is on the side of the first gate insulation layer 231 close to the metal oxide semiconductor layer 24 and is in contact with the metal oxide semiconductor layer 24, and the first gate insulation layer 231 is on the side of the second gate insulation layer 232 away from the metal oxide semiconductor layer 24 and is not in contact with the metal oxide semiconductor layer 24. The thicknesses of the first gate insulation layer 231 and the second gate insulation layer 232 are respectively represented by d₁ and d₂, and the thickness of the gate insulation layer 23 is represented by d, it is satisfied that 3500 Å < d₁+d₂ = d < 5000 Å, and 200 Å < d₂ < 2000 Å, and 4% < d₂/d < 57%.

For example, the first gate insulation layer 231 is a silicon nitride layer, and the second gate insulation layer 232 is a silicon oxide insulation layer.

For example, the ratio of the thickness d₂ of the silicon oxide insulation layer 231 to the thickness d of the gate insulation layer 23 is greater than 4%, which can ensure the uniformity of each layer in the whole oxide thin film transistor. If the thickness d₂ of the silicon oxide insulation layer 231 is too thin, for example, less than 10nm, used as the interface transition layer between the silicon nitride layer 232 and the metal oxide semiconductor layer 24, it may expose the underlying silicon nitride layer 232, resulting in the contact between the silicon nitride layer 232 and the metal oxide semiconductor layer 24, and thereby there is a risk of reduction of the metal oxide semiconductor layer 24. If the thickness d₂ of the silicon oxide insulation layer 231 is too large, it will not be beneficial to improving the productivity, and it will also lead to a small on-state current. The ratio of the thickness d₂ of the silicon oxide insulation layer 231 to the thickness d of the gate insulation layer 23 within the above range can give consideration to both the productivity and the on-state current Iₒₙ, so that the on-state current Iₒₙ can be of an appropriate value.

For example, there are at least a part of a region in the first gate insulation layer 231 satisfying that the percentage of silicon hydrogen bonds (Si-H bonds) in the sum of silicon nitrogen bonds (Si-N bonds), nitrogen hydrogen bonds (N-H bonds) and silicon hydrogen bonds (Si-H bonds) in at least a part of the region is not more than 7%, because the chemical binding ability of the Si-H bond is lower than that of the Si-N bond, and the binding force between the Si-H bond and the Cu metal is weaker than that between the Si-N bond and the Cu metal. During the subsequent high temperature annealing process, H atoms are easier to break away and escape than O atoms. If the percentage of silicon-hydrogen bond (Si-H bond) in the sum of silicon-nitrogen bond (Si-N bond), nitrogen-hydrogen bond (N-H bond) and silicon-hydrogen bond (Si-H bond) is more than 7%, more H element will escape during subsequent annealing process, and thus the binding force between adjacent films will be weaker, and the adhesion between adjacent films will be weaker, thereby the probability of bulging between films will be higher, and in the scheme that the percentage content of silicon hydrogen bond (Si-H bond) is controlled to be no more than 7%, the operation process is simple and convenient, thus saving the equipment cost and the process cost.

For example, there are at least a part of the region in the second gate insulation layer 232 satisfying that the percentage of silicon hydrogen bonds (Si-H bonds) in the sum of silicon oxygen bonds (Si-O bonds), nitrogen hydrogen bonds (N-H bonds) and silicon hydrogen bonds (Si-H bonds) in the at least a part of the region ranges from 1% to 15%, which can make the H element escape less during subsequent annealing and ensure the binding force between adjacent layers, and the probability of bulging phenomenon between the layers is reduced; in addition, in the scheme that the percentage content of silicon hydrogen bond (Si-H bond) in the silicon oxide insulation layer 231 is controlled to be no more than 15%, the operation process is simple and convenient, thus saving the equipment cost and the process cost.

For example, the oxide thin film transistor further includes a source electrode 25 and a drain electrode 26, the capacitance between the metal oxide semiconductor layer 24 and the gate electrode 22 is represented by C, the current between the source electrode 25 and the drain electrode 26 is I_{DS} after the thin film transistor is turned on, the thickness d₂ of the second gate insulation layer 232 is inversely proportional to the current I_{DS}, the second gate insulation layer 232 is a silicon oxide insulation layer, the first gate insulation layer 231 is a silicon nitride layer, and the thickness d₂ of the silicon oxide insulation layer is inversely proportional to the capacitance C between the metal oxide semiconductor layer 24 and the gate electrode 22.

For example, it is satisfied that I_{DS}= W/L*A/((d-d₂)ε₂+d₂ε₁) (Vgs-Vth-Vds/2)Vds, and d₁+d₂=d, in which d represents the total thickness of the gate insulation layer 03, the thickness of the silicon nitride layer 232 is represented by d₂, and the thickness of the silicon oxide insulation layer 231 is represented by d₁. The smaller d₂ is, the greater the current between the source electrode 25 and the drain electrode 26 is, after the thin film transistor is turned on.

For example, the capacitor C=ε₀ε₁*ε₂/4πk (d₁ε₂+d₂ε₁) = ε₀ε₁*ε₂/4πk ((d-d₂) ε₂+d₂ε₁)=ε₀ε₁*ε₂/4πk ((dε₂+d₂(ε₁-ε₂)), in which ε₁ represents the dielectric constant of SiNx in the silicon nitride layer, and ε₂ represents the dielectric constant of SiOx in the silicon oxide insulation layer; ε₁>ε₂; the smaller d₂ is, the larger the capacitance C is.

For example, etching time for gate insulation layer 03 is represented by T, it is satisfied that T=d₂/R₁+(d-d₂)/R₂=d/R₂+d₂ ( R₂-R₁ ) /R₂R₁, in which R₁ represents the etching rate of the silicon nitride layer, R₂ represents the etching rate of the silicon oxide insulation layer, and R₁>R₂, that is, it can be satisfied that the smaller d₂ is, the greater T is.

For example, in one example, in the oxide thin film transistor, 5.7% < d₂/d < 40%.

For example, in one example, the thickness of the metal oxide semiconductor layer 07 is represented by h, and it is satisfied that 10.8% < d₂/d < 11.76%, and 3.5% < h/d < 7.4%.

For example, in one example, the thickness of the metal oxide semiconductor layer is represented by h, and it is satisfied that 21.8% < d₂/d < 37%, and 2% < h/d < 3.5%.

For example, in one example, the thickness of the metal oxide semiconductor layer is represented by h, and it is satisfied that 21.8% < d₂/d < 22.3%, and 2.5% < h/d < 2.9%.

For example, the thickness d₂ of the second gate insulation layer 232 satisfies 200 Å < d₂ < 400 Å.

For example, the thickness d₂ of the silicon oxide insulation layer 231 satisfies 200 Å < d₂ < 400 Å. Preparing the silicon oxide insulation layer 231 to have a thickness in this size range can make the current I_{DS} in the metal oxide semiconductor layer larger and the capacitance C between the metal oxide semiconductor layer 24 and the gate electrode 22 larger.

For example, the metal oxide semiconductor layer 24 adopts a single-layer structure or a stacked structure constituted by a plurality of sublayers.

For example, the metal oxide semiconductor layer 24 adopts a stacked structure constituted by a plurality of sublayers, and the metal oxide semiconductor layer 24 includes a first metal oxide semiconductor layer 241 and a second metal oxide semiconductor layer 242 which are stacked with each other, the compactness of the first metal oxide semiconductor layer 241 is greater than that of the second metal oxide semiconductor layer 242, and the second metal oxide semiconductor layer 242 is arranged on the side of the first metal oxide semiconductor layer 241 close to the base substrate 21 and is in contact with the second gate insulation layer 232.

For example, the material of the metal oxide semiconductor layer 24 includes at least one selected from a group consisting of indium gallium zinc oxide, indium gallium zinc oxide containing Sn and lanthanide metal oxide. For example, in one example, the material of the first metal oxide semiconductor layer 241 and the material of the second metal oxide semiconductor layer 242 may both be indium gallium zinc oxide (IGZO), and the second metal oxide semiconductor layer 242 and the first metal oxide semiconductor layer 241 may have different crystallization degrees according to different formation conditions in the preparation process of the two.

For example, the mobility of the metal oxide semiconductor layer 24 ranges from 5 cm²/vs to 50 cm²/v•s, for example, 5 cm²/vs, 15 cm²/v•s, 20 cm²/v•s, 25 cm²/v•s, 30 cm²/v•s, 40 cm²/v•s, 45 cm²/v•s or 50 cm²/v•s.

For example, the oxide thin film transistor is a bottom gate type thin film transistor, and the oxide thin film transistor 20 further includes a passivation layer 27 arranged on the side, of both the source electrode 25 and the drain electrode 26, away from the base substrate 21. The metal oxide semiconductor layer 24 includes a first surface 24a and a second surface 24b which are opposite to each other, and the second gate insulation layer 232 is in contact with the first surface 24a of the metal oxide semiconductor layer 24, and the passivation layer 27 is in contact with the second surface 24b of the metal oxide semiconductor layer 24.

For example, the passivation layer 27 includes a first passivation layer 271 and a second passivation layer 272 which are stacked with each other, and the material of the first passivation layer 271 includes SiNx and does not include oxygen, in which x is greater than 0; the material of the second passivation layer 272 includes SiOy, in which y is greater than 0; the second passivation layer 272 is on the side of the first passivation layer 271 close to and is in contact with the metal oxide semiconductor layer 24, and the first passivation layer 271 is on the side of the second passivation layer 272 away from the metal oxide semiconductor layer 24 and is not in contact with the metal oxide semiconductor layer 24. The passivation layer 27 can prevent external water vapor from entering the metal oxide semiconductor layer 24 and affecting the performance of the metal oxide semiconductor layer 24.

In the case of no conflict, the embodiments of the present disclosure and the features in the embodiments can be combined with each other to obtain a new embodiment.

The above is only the specific implementation of the present disclosure, but the scope of protection of the present disclosure is not limited thereto, and the scope of protection of the present disclosure should be subject to the scope of protection of the claims.

## Claims

1. An oxide thin film transistor, comprising:
a base substrate (01, 21);
a gate electrode (02, 22) and a metal oxide semiconductor layer (07, 24) that are sequentially stacked on the base substrate (01, 21);
a gate insulation layer (03, 23) provided between the metal oxide semiconductor layer (07, 24) and the gate electrode (02, 22), wherein
the gate insulation layer (03, 23) comprises a silicon oxide insulation layer (031, 231) and a silicon nitride layer (032, 232) which are stacked with each other, wherein the silicon nitride layer (032, 232) adopts a single-layer structure or comprises a plurality of silicon nitride sublayers that are sequentially stacked, and the silicon oxide insulation layer (031, 231) is between the silicon nitride layer (032, 232) and the metal oxide semiconductor layer (07, 24);
**characterised in that** at least a part of a region in the silicon nitride layer (032, 232) satisfies that a percentage content of Si-H bonds in a sum of Si-N bonds, N-H bonds and Si-H bonds is not more than 7%.

2. The oxide thin film transistor according to claim 1, wherein at least a part of the region in the silicon nitride layer (032, 232) satisfies that the percentage content of the Si-H bonds in the sum of Si-N bonds, N-H bonds and Si-H bonds ranges from 0.5% to 7%.

3. The oxide thin film transistor according to claim 1 or 2, wherein the silicon nitride layer (032, 232) adopts a single-layer structure, and the percentage of the Si-H bonds in the at least a part of the region in the silicon nitride layer (032, 232) is positively correlated with a percentage of the Si-H in at least a part of a region in the silicon oxide insulation layer (031, 231), and a stress difference between the gate electrode (02, 22) and the silicon nitride layer (032, 232) ranges from 400 Mpa to 950 Mpa, and the stress difference between the silicon nitride layer (032, 232) and the silicon oxide insulation layer (031, 231) ranges from 50 Mpa to 400 Mpa.

4. The oxide thin film transistor according to claim 1 or 2, wherein the silicon nitride layer (032, 232) comprises a first silicon nitride sublayer (032a) and a second silicon nitride sublayer (032b) which are stacked with each other, wherein the first silicon nitride sublayer (032a) is in contact with the silicon oxide insulation layer (031, 231), and the second silicon nitride sublayer (032b) is on a side of the first silicon nitride sublayer (032a) away from the silicon oxide insulation layer (031, 231) and in contact with the gate electrode (02, 22);
a thickness of the second silicon nitride sublayer (032b) ranges from 2000 Å to 4800 Å, a stress of the second silicon nitride sublayer (032b) ranges from -400 Mpa to -600 Mpa, and a stress difference between the second silicon nitride sublayer (032b) and the gate electrode (02, 22) ranges from 670 Mpa to 870 Mpa; a thickness of the first silicon nitride sublayer (032b) ranges from 500 Å to 2000 Å, a stress of the first silicon nitride sublayer (032a) ranges from -400 Mpa to -800 Mpa, a stress difference between the first silicon nitride sublayer (032a) and the second silicon nitride sublayer (032b) ranges from 0 Mpa to 200 Mpa, a stress difference between the first silicon nitride sublayer (032a) and the silicon oxide insulation layer (031, 231) ranges from 50 Mpa to 400 Mpa, and a stress difference between any adjacent layers does not exceed 1000 Mpa.

5. The oxide thin film transistor according to any one of claims 1 to 4, wherein thicknesses of the silicon nitride layer (032, 232) and the silicon oxide insulation layer (031, 231) are respectively represented by d1 and d2, and a thickness of the gate insulation layer (03, 23) is represented by d, 3500 Å < d₁+d₂ = d < 5000 Å, 200 Å < d₂ < 2000 Å, and 4% < d₂/d < 57%.

6. The oxide thin film transistor according to any one of claims 1 to 5, wherein a source electrode (05, 25) and a drain electrode (06, 26) which are spaced apart from each other are on a side of the metal oxide semiconductor layer (07, 24) away from the base substrate (01, 21), a capacitance between the metal oxide semiconductor layer (07, 24) and the gate electrode (02, 22) is represented by C, and a current between the source electrode (05, 25) and the drain electrode (06, 26) after the thin film transistor is turned on is represented by I_{DS}, a dielectric constant of the silicon oxide insulation layer (031, 231) is smaller than that of the metal oxide semiconductor layer (07, 24), and the thickness d₂ of the silicon oxide insulation layer (031, 231) is inversely proportional to the current I_{DS} in the metal oxide semiconductor layer (07, 24), and the thickness d₂ of the silicon oxide insulation layer (031, 231) is inversely proportional to the capacitance C between the metal oxide semiconductor layer (07, 24) and the gate electrode (02, 22).

7. The oxide thin film transistor according to claim 5, wherein a thickness of the metal oxide semiconductor layer (07, 24) is represented by h, and 200 Å < d₂ < 400 Å, and it is satisfied that 10.8% < d₂/d < 11.76%, and 3.5% < h/d < 7.4%; or it is satisfied that 21.8% < d₂/d < 37%, and 2% < h/d < 3.5%; or it is satisfied that 21.8% < d₂/d < 22.3%, and 2.5% < h/d < 2.9%.

8. The oxide thin film transistor according to claim 6, wherein the oxide thin film transistor (10, 20) is a bottom gate type thin film transistor, and an insulating protection layer (08) is provided on a side, of both the source electrode (05, 25) and the drain electrode (06, 26), away from the base substrate (01, 21), and the metal oxide semiconductor layer (07, 24) is in contact with the insulating protection layer (08) at an interval region which is between the source electrode (05, 25) and the drain electrode (06, 26), and the metal oxide semiconductor layer (07, 24) comprises a first surface (071, 24a) and a second surface (072, 24b) which are opposite to each other, the gate insulation layer (03, 23) is in contact with the first surface (071, 24a) of the metal oxide semiconductor layer (07, 24), and the insulating protection layer (08) is in contact with the second surface (072, 24b) of the metal oxide semiconductor layer (07, 24).

9. The oxide thin film transistor according to claim 8, wherein the insulating protection layer (08) comprises a first insulation layer (08a) and a second insulation layer (08b) which are stacked with each other, the second insulation layer (08b) is on a side of the first insulation layer (08a) close to the metal oxide semiconductor layer (07, 24) and is in contact with the metal oxide semiconductor layer (07, 24), and the first insulation layer (08a) is on a side of the second insulation layer (08b) away from the metal oxide semiconductor layer (07, 24) and is not in contact with the metal oxide semiconductor layer (07, 24); a material of the first insulation layer (08a) comprises SiNₓ, wherein x is greater than 0; a material of the second insulation layer (08b) comprises SiO_{y}, wherein y is greater than 0.

10. The oxide thin film transistor according to any one of claims 1 to 9, wherein the metal oxide semiconductor layer (07, 24) comprises a first metal oxide semiconductor layer (07a, 241) and a second metal oxide semiconductor layer (07b, 242) which are stacked with each other, a crystallization degree of the second metal oxide semiconductor layer (07b, 242) is greater than that of the first metal oxide semiconductor layer (07a, 241), and a conductivity of the second metal oxide semiconductor layer (07b, 242) is lower than that of the first metal oxide semiconductor layer (07a, 241); and the second metal oxide semiconductor layer (07b, 242) is further away from the base substrate (01, 21) than the first metal oxide semiconductor layer (07a, 241);
preferably, a material of the first metal oxide semiconductor layer (07a, 241) comprises at least two metal elements selected from a group consisting of indium, gallium, zinc and tin;
a material of the second metal oxide semiconductor layer (07b, 242) comprises at least two metal elements selected from the group consisting of indium, gallium, zinc and tin.

11. An electronic device, comprising the oxide thin film transistor according to any one of claims 1 to 10.

12. A preparation method of an oxide thin film transistor, comprising:
providing a base substrate (01, 21);
forming a gate electrode (02, 22), a gate insulation layer (03, 23) and a metal oxide semiconductor layer (07, 24) on the base substrate (01, 21), wherein
forming the gate insulation layer (03, 23) comprises: forming a silicon oxide insulation layer (031, 231) and a silicon nitride layer (032, 232), wherein the silicon nitride layer (032, 232) adopts a single-layer structure or comprises a plurality of silicon nitride sublayers sequentially stacked, the silicon nitride layer (032, 232) is formed on a side of the silicon oxide insulation layer (031, 231) close to the gate electrode (02, 22), the silicon nitride layer (032, 232) is in contact with the gate electrode (02, 22), and the silicon oxide insulation layer (031, 231) is formed on a side of the silicon nitride layer (032, 232) close to the metal oxide semiconductor layer (07, 24), and the silicon oxide insulation layer (031, 231) is in contact with the metal oxide semiconductor layer (07, 24), and **characterised in that** at least a part of a region in the silicon nitride layer (032, 232) satisfies that a percentage content of Si-H bonds in a sum of Si-N bonds, N-H bonds and Si-H bonds is not more than 7%.

13. The preparation method according to claim 12, wherein the silicon nitride layer (032, 232) adopts a single-layer structure, and an etching rate of wet etching performing on the silicon nitride layer (032, 232) ranges from 20 Å/s to 30 Å/s.

14. The preparation method according to claim 12 or 13, wherein an etching solution used for etching the silicon nitride layer (032, 232) is a mixed solution of NH3F and HF, and mass percentages of NH3F and HF in the mixed solution of NH3F and HF respectively range from 29.8% to 30.2% and 5.9% to 6.1%.

15. The preparation method according to any one of claims 12 to 14, further comprising: applying a metal electrode film on a side of the metal oxide semiconductor layer (07, 24) away from the base substrate (01, 21), and performing a patterning process on the metal electrode film to form a source electrode (05, 25) and a drain electrode (06, 26) which are spaced apart from each other, and forming an insulating protection layer (08) on a side, of both the source electrode (05, 25) and the drain electrode (06, 26), away from the base substrate (01, 21), wherein the metal oxide semiconductor layer (07, 24) is in contact with the insulating protection layer (08) at an interval region which is between the source electrode (05, 25) and the drain electrode (06, 26).

## Patentansprüche

1. Oxid-Dünnschichttransistor, umfassend:
ein Basissubstrat (01, 21);
eine Gate-Elektrode (02, 22) und eine Metalloxid-Halbleiterschicht (07, 24), die sequentiell auf dem Basissubstrat (01, 21) gestapelt sind;
eine Gate-Isolierschicht (03, 23), vorgesehen zwischen der Metalloxid-Halbleiterschicht (07, 24) und der Gate-Elektrode (02, 22), wobei die Gate-Isolierschicht (03, 23) eine Siliziumoxid-Isolierschicht (031, 231) und eine Siliziumnitridschicht (032, 232) umfasst, die miteinander gestapelt sind, wobei die Siliziumnitridschicht (032, 232) eine einlagige Struktur aufweist oder eine Vielzahl von sequenziell gestapelten Siliziumnitrid-Teilschichten umfasst und die Siliziumoxid-Isolierschicht (031, 231) zwischen der Siliziumnitridschicht (032, 232) und der Metalloxid-Halbleiterschicht (07, 24) ist; **dadurch gekennzeichnet, dass**
mindestens ein Teil eines Bereichs in der Siliziumnitridschicht (032, 232) erfüllt, dass ein prozentualer Anteil von Si-H-Verbindungen in einer Summe von Si-N-Verbindungen, N-H-Verbindungen und Si-H-Verbindungen nicht mehr als 7 % ist.

2. Oxid-Dünnschichttransistor gemäß Anspruch 1, wobei mindestens ein Teil des Bereichs in der Siliziumnitridschicht (032, 232) erfüllt, dass der prozentuale Anteil der Si-H-Verbindungen in der Summe von Si-N-Verbindungen, N-H-Verbindungen und Si-H-Verbindungen im Bereich 0,5 % bis 7 % liegt.

3. Oxid-Dünnschichttransistor gemäß Anspruch 1 oder 2, wobei die Siliziumnitridschicht (032, 232) eine einlagige Struktur aufweist und der Anteil von Si-H-Verbindungen in dem mindestens einen Teil des Bereichs in der Siliziumnitridschicht (032, 232) positiv mit einem Prozentsatz der Si-H in mindestens einem Teil eines Bereichs der Siliziumoxid-Isolierschicht (031, 231) korreliert ist und eine Spannungsdifferenz zwischen der Gate-Elektrode (02, 22) und der Siliziumnitridschicht (032, 232) im Bereich von 400 MPa bis 950 MPa liegt und die Spannungsdifferenz zwischen der Siliziumnitridschicht (032, 232) und der Siliziumoxid-Isolierschicht (031, 231) im Bereich von 50 MPa bis 400 MPa liegt.

4. Oxid-Dünnschichttransistor gemäß Anspruch 1 oder 2, wobei die Siliziumnitridschicht (032, 232) eine erste Siliziumnitrid-Teilschicht (032a) und eine zweite Siliziumnitrid-Teilschicht (032b) umfasst, die miteinander gestapelt sind, wobei die erste Siliziumnitrid-Teilschicht (032a) mit der Siliziumoxid-Isolierschicht (031, 231) in Kontakt ist und die zweite Siliziumnitrid-Teilschicht (032b) auf einer Seite der ersten Siliziumnitrid-Teilschicht (032a) entfernt von der Siliziumoxid-Isolierschicht (031, 231) ist und mit der Gate-Elektrode (02, 22) in Kontakt ist;
eine Dicke der zweiten Siliziumnitrid-Teilschicht (032b) im Bereich von 2000 Å bis 4800 Å liegt, eine Spannung der zweiten Siliziumnitrid-Teilschicht (032b) im Bereich von -400 MPa bis -600 MPa liegt und eine Spannungsdifferenz zwischen der zweiten Siliziumnitrid-Teilschicht (032b) und der Gate-Elektrode (02, 22) im Bereich von 670 MPa bis 870 MPa liegt; eine Dicke der ersten Siliziumnitrid-Teilschicht (032b) im Bereich von 500 Å bis 2000 Å liegt, eine Spannung der ersten Siliziumnitrid-Teilschicht (032a) im Bereich von -400 MPa bis -800 MPa liegt, eine Spannungsdifferenz zwischen der ersten Siliziumnitrid-Teilschicht (032a) und der zweiten Siliziumnitrid-Teilschicht (032b) im Bereich von 0 MPa bis 200 MPa liegt, eine Spannungsdifferenz zwischen der ersten Siliziumnitrid-Teilschicht (032a) und der Siliziumoxid-Isolierschicht (031, 231) im Bereich von 50 MPa bis 400 MPa liegt, und eine Spannungsdifferenz zwischen benachbarten Schichten 1000 MPa nicht überschreitet.

5. Oxid-Dünnschichttransistor gemäß einem der Ansprüche 1 bis 4, wobei Dicken der Siliziumnitridschicht (032, 232) und der Siliziumoxid-Isolierschicht (031, 231) jeweils mit d1 und d2 bezeichnet sind und eine Dicke der Gate-Isolierschicht (03, 23) mit d bezeichnet ist, 3500 Å < d₁+d₂ = d < 5000 Å, 200 Å < d₂ < 2000 Å und 4% < d₂/d < 57%.

6. Oxid-Dünnschichttransistor gemäß einem der Ansprüche 1 bis 5, wobei eine Source-Elektrode (05, 25) und eine Drain-Elektrode (06, 26), die voneinander beabstandet sind, auf einer Seite der Metalloxid-Halbleiterschicht (07, 24) entfernt von dem Basissubstrat angeordnet sind, eine Kapazität zwischen der Metalloxid-Halbleiterschicht (07, 24) und der Gate-Elektrode (02, 22) mit C bezeichnet ist und ein Strom zwischen der Source-Elektrode (05, 25) und der Drain-Elektrode (06, 26) nach dem Einschalten des Dünnschichttransistors mit I_{DS} bezeichnet ist, eine Dielektrizitätskonstante der Siliziumoxid-Isolierschicht (031, 231) kleiner ist als die der Metalloxid-Halbleiterschicht (07, 24) und die Dicke d₂ der Siliziumoxid-Isolierschicht (031, 231) umgekehrt proportional zu dem Strom I_{DS} in der Metalloxid-Halbleiterschicht (07, 24) ist, wobei die Dicke d₂ der Siliziumoxid-Isolierschicht (031, 231) umgekehrt proportional ist zur Kapazität C zwischen der Metalloxid-Halbleiterschicht (07, 24) und der Gate-Elektrode (02, 22).

7. Oxid-Dünnschichttransistor gemäß Anspruch 5, wobei eine Dicke der Metalloxid-Halbleiterschicht (07, 24) mit h bezeichnet ist und 200 Å < d₂ < 400 Å gilt und 10,8 % < d₂/d < 11,76 % und 3,5 % < h/d < 7,4 % erfüllt sind; oder erfüllt ist, dass 21,8 % < d₂/d < 37 % und 2 % < h/d < 3,5 %; oder erfüllt ist, dass 21,8 % < d₂/d < 22,3 % und 2,5 % < h/d < 2,9 %.

8. Oxid-Dünnschichttransistor gemäß Anspruch 6, wobei der Oxid-Dünnschichttransistor (10, 20) ein Dünnschichttransistor vom Bottom-Gate-Typ ist und eine isolierende Schutzschicht (08) an einer Seite sowohl der Source-Elektrode (05, 25) als auch der Drain-Elektrode (06, 26) vorgesehen ist, entfernt von dem Basissubstrat (01, 21), und die Metalloxid-Halbleiterschicht (07, 24) mit der isolierenden Schutzschicht (08) in einem Intervallbereich zwischen der Source-Elektrode (05, 25) und der Drain-Elektrode (06, 26) in Kontakt ist, und die Metalloxidhalbleiterschicht (07, 24) eine erste Oberfläche (071, 24a) und eine zweite Oberfläche (072, 24b) umfasst, die einander gegenüberliegen, die Gate-Isolierschicht (03, 23) mit der ersten Oberfläche (071, 24a) der Metalloxidhalbleiterschicht (07, 24) in Kontakt ist, und die isolierende Schutzschicht (08) in Kontakt mit der zweiten Oberfläche (072, 24b) der Metalloxidhalbleiterschicht (07, 24) ist.

9. Oxid-Dünnschichttransistor gemäß Anspruch 8, wobei die isolierende Schutzschicht (08) eine erste Isolierschicht (08a) und eine zweite Isolierschicht (08b) umfasst, die miteinander gestapelt sind, wobei sich die zweite Isolierschicht (08b) an einer Seite der ersten Isolierschicht (08a) nahe der Metalloxid-Halbleiterschicht (07, 24) ist und mit der Metalloxidhalbleiterschicht (07, 24) in Kontakt ist, und die erste Isolierschicht (08a) auf einer Seite der zweiten Isolierschicht (08b) entfernt von der Metalloxidhalbleiterschicht (07, 24) ist und nicht in Kontakt mit der Metalloxidhalbleiterschicht (07, 24) ist; ein Material der ersten Isolierschicht (08a) SiNx umfasst, wobei x größer als 0 ist; ein Material der zweiten Isolierschicht (08b) SiOy umfasst, wobei y größer als 0 ist.

10. Oxid-Dünnschichttransistor gemäß einem der Ansprüche 1 bis 9, wobei die Metalloxid-Halbleiterschicht (07, 24) eine erste Metalloxid-Halbleiterschicht (07a, 241) und eine zweite Metalloxid-Halbleiterschicht (07b, 242) umfasst, die miteinander gestapelt sind, wobei der Kristallisationsgrad der zweiten Metalloxid-Halbleiterschicht (07b, 242) größer ist als der der ersten Metalloxidhalbleiterschicht (07a, 241) und eine Leitfähigkeit der zweiten Metalloxid-Halbleiterschicht (07b, 242) geringer ist als die der ersten Metalloxid-Halbleiterschicht (07a, 241); und die zweite Metalloxid-Halbleiterschicht (07b, 242) weiter von dem Basissubstrat (01, 21) entfernt ist als die erste Metalloxid-Halbleiterschicht (07a, 241);
vorzugsweise ein Material der ersten Metalloxid-Halbleiterschicht (07a, 241) mindestens zwei Metallelemente umfasst, die aus einer Gruppe ausgewählt sind, die aus Indium, Gallium, Zink und Zinn besteht;
ein Material der zweiten Metalloxid-Halbleiterschicht (07b, 242) mindestens zwei Metallelemente umfasst, die aus der Gruppe ausgewählt sind, die aus Indium, Gallium, Zink und Zinn besteht.

11. Elektronische Vorrichtung, umfassend den Oxid-Dünnschichttransistor gemäß einem der Ansprüche 1 bis 10.

12. Verfahren zur Herstellung eines Oxid-Dünnschichttransistors, umfassend:
Bereitstellen eines Basissubstrats (01, 21);
Ausbilden einer Gate-Elektrode (02, 22), einer Gate-Isolierschicht (03, 23) und einer Metalloxid-Halbleiterschicht (07, 24) auf dem Basissubstrat (01, 21), wobei
das Ausbilden der Gate-Isolierschicht (03, 23) umfasst: Ausbilden einer Siliziumoxid-Isolierschicht (031, 231) und einer Siliziumnitridschicht (032, 232), wobei die Siliziumnitridschicht (032, 232) eine einlagige Struktur aufweist oder eine Vielzahl von sequenziell gestapelten Siliziumnitrid-Teilschichten umfasst, wobei die Siliziumnitridschicht (032, 232) an einer Seite der Siliziumoxid-Isolierschicht (031, 231) nahe der Gate-Elektrode (02, 22) ausgebildet ist, die Siliziumnitridschicht (032, 232) mit der Gate-Elektrode (02, 22) in Kontakt ist und die Siliziumoxid-Isolierschicht (031, 231) an einer Seite der Siliziumnitridschicht (032, 232) nahe der Metalloxid-Halbleiterschicht (07, 24) ausgebildet ist, und die Siliziumoxid-Isolierschicht (031, 231) mit der Metalloxid-Halbleiterschicht (07, 24) in Kontakt ist, und **dadurch gekennzeichnet, dass**
mindestens ein Teil eines Bereichs in der Siliziumnitridschicht (032, 232) erfüllt, dass ein prozentualer Anteil von Si-H-Verbindungen in einer Summe von Si-N-Verbindungen, N-H-Verbindungen und Si-H-Verbindungen nicht mehr als 7 % ist.

13. Verfahren zur Herstellung gemäß Anspruch 12, wobei die Siliziumnitridschicht (032, 232) eine einlagige Struktur aufweist und eine Ätzrate beim Nassätzen der Siliziumnitridschicht (032, 232) im Bereich von 20 Å/s bis 30 Å/s liegt.

14. Verfahren zur Herstellung gemäß Anspruch 12 oder 13, wobei eine zum Ätzen der Siliziumnitridschicht (032, 232) verwendete Ätzlösung eine Mischlösung aus NH₃F und HF ist und Massenanteile von NH₃F und HF in der Mischlösung von NH₃F und HF im Bereich von 29,8 % bis 30,2 % bzw. von 5,9 % bis 6,1 % liegen.

15. Herstellungsverfahren gemäß einem der Ansprüche 12 bis 14, außerdem umfassend: Aufbringen eines Metallelektrodenfilms auf eine Seite der Metalloxidhalbleiterschicht (07, 24) entfernt von dem Basissubstrat (01, 21), und Durchführen eines Strukturierungsprozesses auf dem Metallelektrodenfilm, um eine Source-Elektrode (05, 25) und eine Drain-Elektrode (06, 26) zu bilden, die voneinander beabstandet sind, und Bilden einer isolierenden Schutzschicht (08) an einer Seite sowohl der Source-Elektrode (05, 25) als auch der Drain-Elektrode (06, 26) entfernt von dem Basissubstrat (01, 21), wobei die Metalloxid-Halbleiterschicht (07, 24) mit der isolierenden Schutzschicht (08) in einem Zwischenbereich, der sich zwischen der Source-Elektrode (05, 25) und der Drain-Elektrode (06, 26) befindet, in Kontakt ist.

## Revendications

1. Transistor à film mince d'oxyde, comprenant :
un substrat de base (01, 21) ;
une électrode de grille (02, 22) et une couche de semi-conducteur à oxyde métallique (07, 24) qui sont empilées séquentiellement sur le substrat de base (01, 21) ;
une couche d'isolation de grille (03, 23) prévue entre la couche de semi-conducteur à oxyde métallique (07, 24) et l'électrode de grille (02, 22), dans lequel
la couche d'isolation de grille (03, 23) comprend une couche d'isolation d'oxyde de silicium (031, 231) et une couche de nitrure de silicium (032, 232) qui sont empilées l'une sur l'autre, dans lequel la couche de nitrure de silicium (032, 232) adopte une structure monocouche ou comprend une pluralité de sous-couches de nitrure de silicium qui sont empilées séquentiellement, et la couche d'isolation d'oxyde de silicium (031, 231) se trouve entre la couche de nitrure de silicium (032, 232) et la couche de semi-conducteur à oxyde métallique (07, 24) ;
**caractérisé en ce qu'**au moins une partie d'une région dans la couche de nitrure de silicium (032, 232) remplit une condition qu'une teneur en pourcentage de liaisons Si-H dans une somme de liaisons Si-N, de liaisons N-H et de liaisons Si-H ne dépasse pas 7 %.

2. Transistor à film mince d'oxyde selon la revendication 1, dans lequel au moins une partie de la région dans la couche de nitrure de silicium (032, 232) remplit une condition que la teneur en pourcentage des liaisons Si-H dans la somme de liaisons Si-N, de liaison de N-H et de liaison de Si-H se trouve dans une plage de 0,5 % à 7 %.

3. Transistor à film mince d'oxyde selon la revendication 1 ou 2, dans lequel la couche de nitrure de silicium (032, 232) adopte une structure monocouche, et le pourcentage des liaisons Si-H dans l'au moins une partie de la région dans la couche de nitrure de silicium (032, 232) est en corrélation positive avec un pourcentage des liaisons Si-H dans au moins une partie d'une région dans la couche d'isolation d'oxyde de silicium (031, 231), et une différence de contraintes entre l'électrode de grille (02, 22) et la couche de nitrure de silicium (032, 232) se trouve dans une plage de 400 Mpa à 950 Mpa, et la différence de contraintes entre la couche de nitrure de silicium (032, 232) et la couche d'isolation d'oxyde de silicium (031, 231) se trouve dans une plage de 50 Mpa à 400 Mpa.

4. Transistor à film mince d'oxyde selon la revendication 1 ou 2, dans lequel la couche de nitrure de silicium (032, 232) comprend une première sous-couche de nitrure de silicium (032a) et une deuxième sous-couche de nitrure de silicium (032b) qui sont empilées l'une sur l'autre, dans lequel la première sous-couche de nitrure de silicium (032a) est en contact avec la couche d'isolation d'oxyde de silicium (031, 231) et la deuxième sous-couche de nitrure de silicium (032b) se trouve d'un côté de la première sous-couche de nitrure de silicium (032a) éloigné de la couche d'isolation d'oxyde de silicium (031, 231) et en contact avec l'électrode de grille (02, 22) ;
une épaisseur de la deuxième sous-couche de nitrure de silicium (032b) se trouve dans une plage de 2000 Å à 4800 Å, une contrainte de la deuxième sous-couche de nitrure de silicium (032a) se trouve dans une plage de -400 Mpa à -600 Mpa, et une différence de contraintes entre la deuxième sous-couche de nitrure de silicium (032b) et l'électrode de grille (02, 22) se trouve dans une plage de 670 Mpa à 870 Mpa ; une épaisseur de la première sous-couche de nitrure de silicium (032a) se trouve dans une plage de 500 Å à 2000 Å, une contrainte de la première sous-couche de nitrure de silicium (032a) se trouve dans une plage de -400 Mpa à -800 Mpa, une différence de contraintes entre la première sous-couche de nitrure de silicium (032a) et la deuxième sous-couche de nitrure de silicium (032b) se trouve dans une plage de 0 Mpa à 200 Mpa, une différence le contrainte entre la première sous-couche de nitrure de silicium (032a) et la couche d'isolation d'oxyde de silicium (031, 231) se trouve dans une plage de 50 Mpa à 400 Mpa, et une différence de contraintes entre des couches adjacentes ne dépasse pas 1000 Mpa.

5. Transistor à film mince d'oxyde selon l'une quelconque des revendications 1 à 4, dans lequel des épaisseurs de la couche de nitrure de silicium (032, 232) et de la couche d'isolation d'oxyde de silicium (031, 231) sont représentées respectivement par d1 et d2, et une épaisseur de la couche d'isolation de grille (03, 23) est représentée par d, 3500 Å < d₁+d₂ = d < 5000 Å, 200 Å < d₂ < 2000 Å, et 4 % < d₂/d < 57 %.

6. Transistor à film mince d'oxyde selon l'une quelconque des revendications 1 à 5, dans lequel une électrode de source (05, 25) et une électrode de drain (06, 26) qui sont espacées l'une de l'autre se trouve d'un côté de la couche de semi-conducteur à oxyde métallique (07, 24) éloigné du substrat de base (01, 21), une capacité entre la couche de semi-conducteur à oxyde métallique (07, 24) et l'électrode de grille (02, 22) est représentée par C, et un courant entre l'électrode de source (05, 25) et l'électrode de drain (06, 26) après la mise sous tension du transistor à film mince est représenté par I_{DS}, une constante diélectrique de la couche d'isolation d'oxyde de silicium (031, 231) est inférieure à celle de la couche de semi-conducteur à oxyde métallique (07, 24), et l'épaisseur d₂ de la couche d'isolation d'oxyde de silicium (031, 231) est inversement proportionnelle au courant I_{DS} dans la couche de semi-conducteur à oxyde métallique (07, 24), et l'épaisseur d₂ de la couche d'isolation d'oxyde de silicium (031, 231) est inversement proportionnelle à la capacité C entre la couche de semi-conducteur à oxyde métallique (07, 24) et l'électrode de grille (02, 22).

7. Transistor à film mince d'oxyde selon la revendication 5, dans lequel une épaisseur de la couche de semi-conducteur à oxyde métallique (07, 24) est représentée par h, et 200 Å < d₂ < 400 Å, et les conditions suivantes sont remplies : 10,8 % < d₂/d < 11,76 % et 3,5 % < h/d < 7,4 % ; ou les conditions suivantes sont remplies : 21,8 % < d₂/d < 37 % et 2 % < h/d < 3,5 % ; ou les conditions suivantes sont remplies : 21,8 % < d₂/d < 22,3 % et 2,5 % < h/d < 2,9 %.

8. Transistor à film mince d'oxyde selon la revendication 6, dans lequel le transistor à film mince d'oxyde (10, 20) est un transistor à film mince de type à grille inférieure, et une couche de protection d'isolation (08) est prévue d'un côté, à la fois de l'électrode de source (05, 25) et de l'électrode de drain (06, 26), éloigné du substrat de base (01, 21), et la couche de semi-conducteur à oxyde métallique (07, 24) est en contact avec la couche de protection d'isolation (08) au niveau d'une région d'intervalle qui se trouve entre l'électrode de source (05, 25) et l'électrode de drain (06, 26), et la couche de semi-conducteur à oxyde métallique (07, 24) comprend une première surface (071, 24a) et une deuxième surface (072, 24b) qui sont à l'opposé l'une de l'autre, la couche d'isolation de grille (03, 23) est en contact avec la première surface (071, 24a) de la couche de semi-conducteur à oxyde métallique (07, 24), et la couche de protection d'isolation (08) est en contact avec la deuxième surface (072, 24b) de la couche de semi-conducteur à oxyde métallique (07, 24).

9. Transistor à film mince d'oxyde selon la revendication 8, dans lequel la couche de protection d'isolation (08) comprend une première couche d'isolation (08a) et une deuxième couche d'isolation (08b) qui sont empilées l'une sur l'autre, la deuxième couche d'isolation (08b) se trouve d'un côté de la première couche d'isolation (08a) proche de la couche de semi-conducteur à oxyde métallique (07, 24) et est en contact avec la couche de semi-conducteur à oxyde métallique (07, 24), et la première couche d'isolation (08a) est d'un côté de la deuxième couche d'isolation (08b) éloigné de la couche de semi-conducteur à oxyde métallique (07, 24) et n'est pas en contact avec la couche de semi-conducteur à oxyde métallique (07, 24) ; un matériau de la première couche d'isolation (08a) comprend du SiNₓ, dans lequel x est supérieur à 0 ; un matériau de la deuxième couche d'isolation (08b) comprend du SiO_{y}, dans lequel y est supérieur à 0.

10. Transistor à film mince d'oxyde selon l'une quelconque des revendications 1 à 9, dans lequel la couche de semi-conducteur à oxyde métallique (07, 24) comprend une première couche de semi-conducteur à oxyde métallique (07a, 241) et une deuxième couche de semi-conducteur à oxyde métallique (07b, 242) qui sont empilées l'une sur l'autre, un degré de cristallisation de la deuxième couche de semi-conducteur à oxyde métallique (07b, 242) est supérieur à celui de la première couche de semi-conducteur à oxyde métallique (07a, 241), et une conductivité de la deuxième couche de semi-conducteur à oxyde métallique (07b, 242) est inférieure à celle de la première couche de semi-conducteur à oxyde métallique (07a, 241) ; et la deuxième couche de semi-conducteur à oxyde métallique (07b, 242) est plus éloignée du substrat de base (01, 21) que la première couche de semi-conducteur à oxyde métallique (07a, 241) ;
de préférence, un matériau de la première couche de semi-conducteur à oxyde métallique (07a, 241) comprend au moins deux éléments métalliques choisis dans un groupe se composant d'indium, de gallium, de zinc et d'étain ;
un matériau de la deuxième couche de semi-conducteur à oxyde métallique (07b, 242) comprend au moins deux éléments métalliques choisis dans le groupe se composant d'indium, de gallium, de zinc et d'étain.

11. Dispositif électronique, comprenant le transistor à film mince d'oxyde selon l'une quelconque des revendications 1 à 10.

12. Procédé de préparation d'un transistor à film mince d'oxyde, comprenant :
la fourniture d'un substrat de base (01, 21) ;
la formation d'une électrode de grille (02, 22), d'une couche d'isolation de grille (03, 23) et d'une couche de semi-conducteur à oxyde métallique (07, 24) sur le substrat de base (01, 21), dans lequel
la formation de la couche d'isolation de grille (03, 23) comprend : la formation d'une couche d'isolation d'oxyde de silicium (031, 231) et d'une couche de nitrure de silicium (032, 232), dans lequel la couche de nitrure de silicium (032, 232) adopte une structure monocouche ou comprend une pluralité de sous-couches de nitrure de silicium qui sont empilées séquentiellement, la couche de nitrure de silicium (032, 232) est formée d'un côté de la couche d'isolation d'oxyde de silicium (031, 231) proche de l'électrode de grille (02, 22), la couche de nitrure de silicium (032, 232) est en contact avec l'électrode de grille (02, 22), et la couche d'isolation d'oxyde de silicium (031, 231) est formée d'un côté de la couche de nitrure de silicium (032, 232) proche de la couche de semi-conducteur à oxyde métallique (07, 24), et la couche d'isolation d'oxyde de silicium (031, 231) est en contact avec la couche de semi-conducteur à oxyde métallique (07, 24), et
**caractérisé en ce qu'**au moins une partie d'une région dans la couche de nitrure de silicium (032, 232) remplit une condition qu'une teneur en pourcentage de liaisons Si-H dans une somme de liaisons Si-N, de liaisons N-H et de liaisons Si-H ne dépasse pas 7 %.

13. Procédé de préparation selon la revendication 12, dans lequel la couche de nitrure de silicium (032, 232) adopte une structure monocouche, et une vitesse de gravure de gravure par voie humide réalisée sur la couche de nitrure de silicium (032, 232) se trouve dans une plage de 20 Â/s à 30 Â/s.

14. Procédé de préparation selon la revendication 12 ou 13, dans lequel une solution de gravure utilisée pour la gravure de la couche de nitrure de silicium (032, 232) est une solution mixte de NH₃F et de HF, et des pourcentages en masse de NH₃F et de HF dans la solution mixte de NH₃F et de HF se trouvent respectivement dans les plages de 29,8 % à 30,2 % et de 5,9 % à 6,1 %.

15. Procédé de préparation selon l'une quelconque des revendications 12 à 14, comprenant en outre : l'application d'un film d'électrode métallique d'un côté de la couche de semi-conducteur à oxyde métallique (07, 24) éloigné du substrat de base (01, 21), et la réalisation d'un processus de structuration sur le film d'électrode métallique pour former une électrode de source (05, 25) et une électrode de drain (06, 26) qui sont espacées l'une de l'autre, et la formation d'une couche de protection d'isolation (08) d'un côté, à la fois de l'électrode de source (05, 25) et de l'électrode de drain (06, 26), éloigné du substrat de base (01, 21), dans lequel la couche de semi-conducteur à oxyde métallique (07, 24) est en contact avec la couche de protection d'isolation (08) au niveau d'une région d'intervalle qui se trouve entre l'électrode de source (05, 25) et l'électrode de drain (06, 26).
